(19) Europäisches Patentamt
European Patent Office
Office européen des brevets

(11) EP 4 206 294 A1

(12) EUROPEAN PATENT APPLICATION
published in accordance with Art. 153(4) EPC

(43) Date of publication:
**05.07.2023 Bulletin 2023/27**

(21) Application number: **21905004.4**

(22) Date of filing: **29.06.2021**

(51) International Patent Classification (IPC):
***C09J 4/02*** (2006.01) ***C09J 7/10*** (2018.01)
***C09J 7/30*** (2018.01) ***C09J 123/00*** (2006.01)
***C09J 123/08*** (2006.01) ***C09J 151/06*** (2006.01)
***H01L 31/048*** (2014.01)

(52) Cooperative Patent Classification (CPC):
**C09J 4/00; C09J 7/10; C09J 7/30; C09J 123/00; C09J 123/08; C09J 151/06; H01L 31/048;**
Y02E 10/50

(86) International application number:
**PCT/CN2021/103007**

(87) International publication number:
**WO 2022/127070 (23.06.2022 Gazette 2022/25)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **17.12.2020 CN 202011497426**
**17.12.2020 CN 202011497406**

(71) Applicant: **Hangzhou First Applied Material Co., Ltd.**
**Hangzhou, Zhejiang 311300 (CN)**

(72) Inventors:
- **TANG, Guodong**
  **Hangzhou, Zhejiang 311300 (CN)**
- **HOU, Hongbing**
  **Hangzhou, Zhejiang 311300 (CN)**
- **ZHOU, Xinrui**
  **Hangzhou, Zhejiang 311300 (CN)**
- **LAN, Songqing**
  **Hangzhou, Zhejiang 311300 (CN)**
- **WANG, Long**
  **Hangzhou, Zhejiang 311300 (CN)**
- **WEI, Mengjuan**
  **Hangzhou, Zhejiang 311300 (CN)**
- **ZHOU, Guangda**
  **Hangzhou, Zhejiang 311300 (CN)**

(74) Representative: **Biggi, Cristina**
**Bugnion S.p.A.**
**Viale Lancetti 17**
**20158 Milano (IT)**

# (54) ENCAPSULATING COMPOSITION, COMPOSITION, ENCAPSULATING GLUE FILM, ELECTRONIC COMPONENT AND SOLAR CELL ASSEMBLY

(57) The present disclosure provides an encapsulating composition, a composition, an encapsulating glue film, an electronic component and a solar cell assembly. The encapsulating composition comprises polyolefin resin, polyethylene glycol dimethacrylate and organic peroxide, and the structural formula of the polyethylene glycol dimethacrylate is represented by a formula (I), wherein n is an integer of 2-5. Polar ethylene glycol dimethacrylate and non-polar polyolefin resin are thermodynamically incompatible, and when the polyolefin resin is heated and melted, the ethylene glycol dimethacrylate is delaminated and aggregated in the polyolefin resin. Meanwhile, a polymer network structure that has a three-dimensional network structure and that has several ester groups and ether bonds is formed in situ in a polyolefin resin matrix by curing, and the polymer network structure may adsorb residual metal ions in the polyolefin resin, thereby reducing the mobility of the metal ions, so as to improve the dry insulation resistance of the polyolefin resin. In addition, said composition has simple components, readily available raw materials and low costs.

EP 4 206 294 A1

## Description

### Technical Field

The present disclosure relates to the technical field of encapsulating materials, and specifically to an encapsulating composition, a composition, an encapsulating glue film, an electronic component and a solar cell assembly.

### Background

Since a polyolefin material (for example, ethylene-octene copolymer catalyzed and polymerized by metallocene) has good light transmission, water resistance and high elasticity, and is non-corrosive, the polyolefin material is ideal for an encapsulating material of an electronic component, for example, the polyolefin material is used for electronic components such as a solar panel, a liquid crystal panel, an electroluminescent device, a plasma display device and a touch screen. For the electronic components, it is generally expected that the encapsulating material in snugly contact with the electronic components has high insulation resistance (more than $1.0\times10^{15}\Omega\cdot cm$), such that leakage current of a device may be reduced, thereby increasing a security coefficient. However, the volume resistivity of the polyolefin material is affected due to residual trace metal elements, generally, the volume resistivity of the polyolefin material is only $1.0\times10^{14}\Omega\cdot cm$, which cannot meet a requirement for encapsulating the electronic components, especially under a high voltage, for example, the polyolefin material cannot meet the requirements of the solar panel at a system voltage of 1500V or higher. Therefore, in the market, polyolefin synthesis manufacturers may increase the volume resistivity of polyolefin by means of special modification of metal catalysts and special control of a polymerization process, often leading to an increase in production costs.

### Summary

The present disclosure is mainly intended to provide an encapsulating composition, a composition, an encapsulating glue film, an electronic component and a solar cell assembly, so as to solve the problem in the related art of high production costs caused by an increase in the volume resistivity of polyolefin.

In order to implement the above objective, an aspect of the present disclosure provides an encapsulating composition, the encapsulating composition includes polyolefin resin, polyethylene glycol dimethacrylate and organic peroxide, and the structural formula of the polyethylene glycol dimethacrylate is represented as:

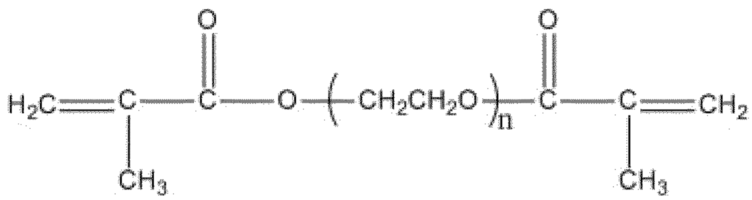
,

wherein n is an integer of 2-5.

By means of applying the technical solution of the present disclosure, polar polyethylene glycol dimethacrylate and non-polar polyolefin resin are thermodynamically incompatible, and when the polyolefin resin is heated and melted, the polyethylene glycol dimethacrylate is delaminated and aggregated in the polyolefin resin. Meanwhile, primary radicals produced by means of thermal decomposition of the organic peroxide make the gathered polyethylene glycol dimethacrylate rapidly undergo a radical polymerization reaction, such that a polymer network structure that has a three-dimensional network structure and that has several ester groups and ether bonds is formed in situ in a polyolefin resin matrix. The polymer network structure can adsorb residual metal ions in the polyolefin resin, thereby reducing the mobility of the metal ions, so as to improve the dry insulation resistance of the polyolefin resin. In addition, the encapsulating composition has simple components, readily available raw materials and low costs.

If the n is less than 2, the molecular weight of the polyethylene glycol dimethacrylate is too low, resulting in easy precipitation of the polyethylene glycol dimethacrylate in the polyolefin resin matrix, such that the effect of the polyethylene glycol dimethacrylate cannot achieved; and if the n is greater than 5, the viscosity of the polyethylene glycol dimethacrylate is too large, not facilitating mixing processing, such that a synergistic effect of the polyethylene glycol dimethacrylate with the organic peroxide is not achieved.

In order to implement the above objective, another aspect of the present disclosure further provides an encapsulating composition. The encapsulating composition includes vinyl polymer, diethylene glycol dimethacrylate and organic peroxide, and the structural formula of the diethylene glycol dimethacrylate is represented as:

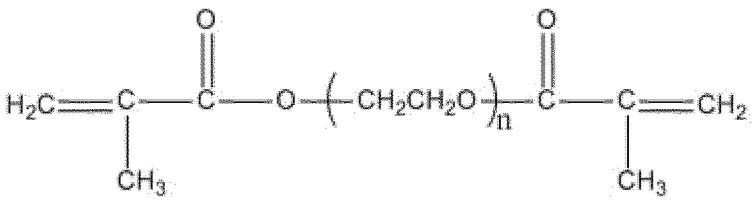

,

wherein n=2.

Since polyethylene glycol dimethacrylate in the encapsulating composition is a polymer network structure that has a three-dimensional network structure and that has several ester groups and ether bonds. The polymer network structure can adsorb residual metal ions in the vinyl polymer, thereby reducing the mobility of the metal ions, so as to improve the dry insulation resistance of the vinyl polymer. In addition, a method for preparing an encapsulating glue film by using the encapsulating composition is simple, and has readily available raw materials and low costs.

Another aspect of the present disclosure provides a composition. The composition is a non-peroxide initiated composition, and includes polyolefin resin and a monomer. The monomer includes a compound shown in a structural formula I:

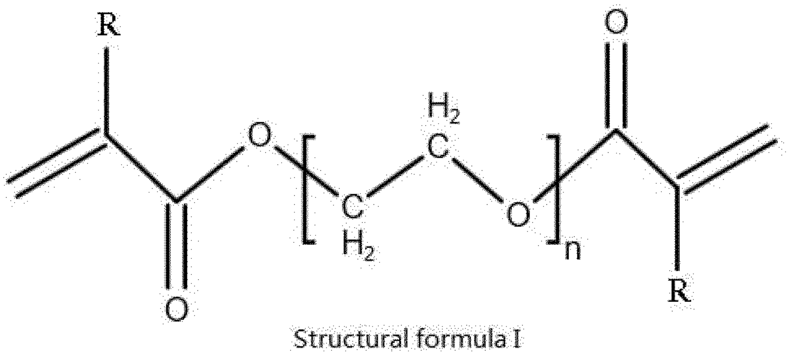

Structural formula I

,

wherein R is H or methyl, and n is an integer of 2-5; and a polymerization mode of the monomer is ultraviolet light initiated polymerization, or radiation initiated polymerization, or microwave initiated polymerization.

By means of applying the technical solution of the present disclosure, the polyolefin resin and the monomer can be uniformly mixed at room temperature. However, when the polyolefin resin is heated and melted, the polar monomer and the non-polar polyolefin resin are thermodynamically incompatible, resulting in certain aggregation of monomer molecules. Meanwhile, the monomer forms a hyperbranched polymer that has several ester groups and ether bonds in situ in the polyolefin resin matrix by means of ultraviolet light initiated polymerization or radiation initiated polymerization. The hyperbranched polymer structure can weaken the mobility of the metal ions or deprive the metal ions of electron conduction, thereby reducing the mobility of the metal ions, so as to improve the dry insulation resistance of the polyolefin resin. In addition, the composition has simple components, readily available raw materials, less process steps, and low costs. If the n is less than 2, the molecular weight of the monomer is too low, resulting in easy precipitation of the monomer in the polyolefin resin matrix, such that the effect of the monomer cannot achieved; and if the n is greater than 5, the viscosity of the monomer is too large, not facilitating mixing processing, and increasing polymerization difficulty.

Another aspect of the present disclosure further provides a composition, the composition includes polyolefin resin, and a three-dimensional polymer containing ester groups and ether bonds, where a structural formula of a monomer forming the three-dimensional polymer is represented as:

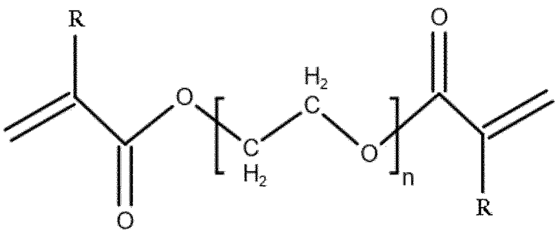

,

wherein n is an integer of 2-5, and R is H or $CH_3$.

By means of applying the technical solution of the present disclosure, the structure of the three-dimensional polymer generally refers to a polymer system which is formed by means of polymerization of a dobby monomer in a three-dimensional space. Since the monomer forming the three-dimensional polymer in the present disclosure contains two olefinic unsaturated bonds, the three-dimensional polymer obtained by means of polymerization of the monomer contains several ether bonds and ester groups. Oxygen atoms in the ether bonds and the ester groups contain lone pair electrons. In addition, by means of the synergistic effect between the two oxygen atoms, the residual metal ions in the polyolefin resin are chelated together, such that the metal ions are weakened or deprived their electron conduction, so as to improve the insulation resistance of the polyolefin resin. In addition, the composition has simple components, readily available raw materials, and low costs.

If the n is less than 2, the ether bonds are absent in a polyester compound, such that the effect of synergistically chelating the metal ions cannot be achieved; and if the n is greater than 5, the molecular weight of the monomer is too large, resulting in a large steric effect, such that the three-dimensional polymer containing several ester groups and ether bonds cannot be formed by means of polymerization.

Another aspect of the present disclosure provides an encapsulating glue film, which is obtained by mixing and performing melt extrusion on components in a composition. The composition is the above encapsulating composition, or the composition is the above composition.

Still another aspect of the present disclosure provides an electronic component. The electronic component includes any one of a solar cell, a liquid crystal panel, an electroluminescent device, a plasma display device or a touch screen. At least one surface of the electronic component is in contact with an encapsulating glue film; and the encapsulating glue film is the foregoing encapsulating glue film.

Still another aspect of the present disclosure provides a solar cell assembly. The solar cell assembly includes a solar cell. At least one surface of the solar cell is in contact with an encapsulating glue film; and the encapsulating glue film is the foregoing encapsulating glue film.

## Detailed Description of the Embodiments

It is to be noted that the embodiments in this disclosure and the features in the embodiments may be combined with one another without conflict. The present disclosure will be described below in detail with reference to the embodiments.

As analyzed in the background, there is a problem in the related art of high production costs caused by an increase in the volume resistivity of polyolefin, in order to solve the problem, the present disclosure provides an encapsulating composition, a composition, an encapsulating glue film, an electronic component and a solar cell assembly.

A typical implementation of the present disclosure provides an encapsulating composition, the encapsulating composition includes polyolefin resin, polyethylene glycol dimethacrylate and organic peroxide, and the structural formula of the polyethylene glycol dimethacrylate is represented as:

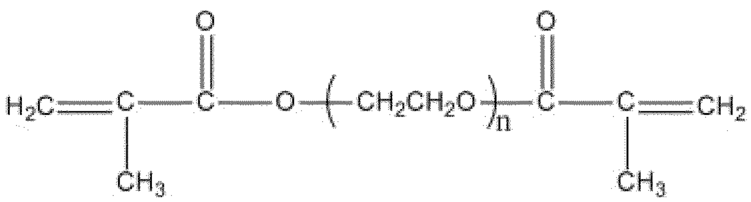

,

wherein n is an integer of 2-5.

Polar polyethylene glycol dimethacrylate and non-polar polyolefin resin are thermodynamically incompatible, and when the polyolefin resin is heated and melted, the polyethylene glycol dimethacrylate is delaminated and aggregated in the polyolefin resin. Meanwhile, primary radicals produced by means of thermal decomposition of the organic peroxide make the gathered polyethylene glycol dimethacrylate rapidly undergo a radical polymerization reaction, such that a polymer network structure that has a three-dimensional network structure and that has several ester groups and ether bonds is formed in situ in a polyolefin resin matrix, the polymer network structure can adsorb residual metal ions in the polyolefin resin, thereby reducing the mobility of the metal ions, so as to improve the dry insulation resistance of the polyolefin resin, in addition, the encapsulating composition has simple components, readily available raw materials and low costs.

If the n is less than 2, the molecular weight of the polyethylene glycol dimethacrylate is too low, resulting in easy precipitation of the polyethylene glycol dimethacrylate in the polyolefin resin matrix, such that the effect of the polyethylene glycol dimethacrylate cannot achieved; and if the n is greater than 5, the viscosity of the polyethylene glycol dimethacrylate is too large, not facilitating mixing processing, such that a synergistic effect of the polyethylene glycol

dimethacrylate with the organic peroxide is not achieved.

In an embodiment of the present disclosure, a mass ratio of the polyethylene glycol dimethacrylate to the organic peroxide is 0.3:1-2.1:1, preferably 0.7:1-1.7:1.

The mass ratio of the polyethylene glycol dimethacrylate to the organic peroxide is controlled within the above range, such that a synergistic effect between two groups is better achieved, so as to improve the crosslinking degree of a polymer network formed by polyolefin, thereby improving the dry insulation resistance of the polyolefin resin.

On the basis of taking the molecular weight and viscosity of the polyethylene glycol dimethacrylate into consideration, in order to further improve synergistic performance between the polyethylene glycol dimethacrylate and the organic peroxide, preferably, the n is 2-4; preferably, the n is 2-3; and further preferably, the n is 2.

Since a polyolefin material has good light transmission, water resistance and high elasticity, and is non-corrosive, the polyolefin material is ideal for an encapsulating material of an electronic component. In the present disclosure, in order to further improve the performance of the polyolefin material so as to obtain the encapsulating material having excellent performance, preferably, the encapsulating composition includes, by weight: 100 parts of the polyolefin resin; 0.1-3 parts of the polyethylene glycol dimethacrylate; and 0.1-2 parts of the organic peroxide; preferably, the polyethylene glycol dimethacrylate is 0.15-2.5 parts, further preferably 0.2-2.0 parts, further preferably 0.3-1.5 parts, and still further preferably 0.5-1.2 parts; preferably, the organic peroxide is selected from a combination of any one or more of diacyl peroxide, dialkyl peroxide, peroxide ester and ketal peroxide; preferably, the peroxide ester is selected from a combination of any one or more of ethyl 3,3-bis(tert-butylperoxy)butyrate, ethyl 3,3-bis(tert-amylperoxy)butyrate, tert-butyl peroxybenzoate, tert-butyl peroxyacetate, tert-butylperoxy isopropyl carbonate, tert-butyl peroxy-3,5,5-trimethylhexanoate, tert-butylperoxy 2-ethylhexyl carbonate, n-butyl 4,4-bis(tert-butylperoxy)valerate, tert-amyl peroxybenzoate, tert amyl peroxyacetate, tert-amyl peroxy-3,5,5-trimethylhexanoate, tert-amyl peroxy 2-ethylhexyl carbonate, tert amyl peroxyisobutyrate and 2,5-dimethyl-2,5-bis(benzoylperoxy)-hexane; preferably, the diacyl peroxide is selected from a combination of any one or more of benzoyl peroxide, lauric peroxide and decanoic acid peroxide; preferably, the ketal peroxide is selected from a combination of any one or more of 2,2-di(tert-butylperoxy)butane, 1,1-di(tert-butylperoxy)cyclohexane, 1,1-di-(tert-butylperoxy)-3,3,5-trimethylcyclohexane, 1,1-bis(tert-amylperoxy)cyclohexane and 1,1-di-(tert-amylperoxy)-3,3,5-trimethylcyclohexane; and preferably, the dialkyl peroxide is diisopropylbenzene peroxide and/or 2,5-dimethyl-2,5-di(tert-butylperoxy)hexane.

The encapsulating composition having a relationship of the above parts by weight better facilitates the synergistic effect between the components, such that the performance of the components is achieved more fully, so as to obtain the encapsulating glue film with excellent performance. Since the use amount of the polyethylene glycol dimethacrylate is too little, the volume resistivity of polyolefin cannot be obviously improved; and when the use amount of the polyethylene glycol dimethacrylate is too much, a negative effect of precipitation of an additive is caused. Preferably, the use amount of the polyethylene glycol dimethacrylate may further achieve the synergistic effect with the organic peroxide.

In order to further improve the synergistic performance between the polyolefin resin and the polyethylene glycol dimethacrylate and the organic peroxide, so as to improve the dry insulation resistance of the polyolefin resin, preferably, the polyolefin resin includes copolymer of ethylene and $C_{3-20}$ $\alpha$ olefin, preferably, the polyolefin resin is selected from a combination of any one or more of ethylene-propylene copolymer, ethylene-butene copolymer, ethylene-octene copolymer, and ethylene-propylene-octene copolymer; preferably, the melting point of the polyolefin resin is 40-80 °C; preferably, the melt index of the polyolefin resin is 3-20 g/10 min, the melting point of the polyolefin resin is determined by a melting peak temperature of a Differential Scanning Calorimeter (DSC).

In order to improve the crosslinking density of the polyolefin resin, preferably, the encapsulating composition further includes, by weight, 0.2-3 parts of a co-crosslinking agent, preferably, the co-crosslinking agent is a compound that includes at least three double bonds; further preferably, the co-crosslinking agent is the compound having an annular structure; and further preferably, the co-crosslinking agent is triallyl isocyanurate and/or triallyl cyanurate.

In an embodiment of the present disclosure, the encapsulating composition further includes, by weight, 0.1-1.5 parts of organosiloxane, preferably, the organosiloxane simultaneously includes an olefinic group and a hydrolyzable group; further preferably, the organosiloxane is trialkoxysilane; and further preferably, the trialkoxysilane is selected from a combination of any one or more of $\gamma$-methacryloyloxypropyl trimethoxysilane, vinyltrimethoxysilane, triethoxyvinylsilane, vinyl tris($\beta$-methoxyethoxy) silane, and allyltrimethoxysilane.

The organosiloxane is organosiloxane that simultaneously has the olefinic group and the hydrolyzable group, which may improve the interface adhesion of polyolefin. Definitely, those skilled in the art may also add, according to actual requirements, any one or more of an antioxidant, a light stabilizer, an ultraviolet absorbent, an anti-coking agent, a plasticizer, an antistatic agent, an anticorrosive agent and an inorganic salt filler in the encapsulating composition.

A typical implementation of the present disclosure provides an encapsulating composition, the encapsulating composition includes vinyl polymer, diethylene glycol dimethacrylate and organic peroxide, and the structural formula of the diethylene glycol dimethacrylate is represented as:

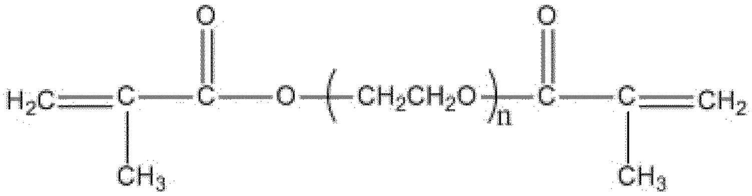

,

wherein n = 2.

Since polyethylene glycol dimethacrylate in the encapsulating composition is a polymer network structure that has a three-dimensional network structure and that has several ester groups and ether bonds, the polymer network structure can adsorb residual metal ions in the vinyl polymer, thereby reducing the mobility of the metal ions, so as to improve the dry insulation resistance of the vinyl polymer. In addition, a method for preparing an encapsulating glue film by using the encapsulating composition is simple, and has readily available raw materials and low costs.

If the content of the organic peroxide is too low, primary radicals produced in a reaction process are too few, and the density of a converged network of the diethylene glycol dimethacrylate initiated and formed is too low, such that an effect that the polymer network structure adsorbs the residual metal ions in the polyolefin resin cannot be well embodied; and if the content of the organic peroxide is too much, more organic peroxide residues are left in the encapsulating glue film, easily causing bubbles. Therefore, in order to rationally control the use amount of the organic peroxide, so as to make the diethylene glycol dimethacrylate polymerized into a network structure as much as possible, preferably, the mass ratio of the diethylene glycol dimethacrylate to the organic peroxide is 3-20:1, preferably 5-15:1, and further preferably 7-12:1.

In order to promote the synergism among the vinyl polymer, the diethylene glycol dimethacrylate and the organic peroxide as much as possible, so as to further improve the adsorption efficiency of the network structure of the polyethylene glycol dimethacrylate for the residual metal ions in the vinyl polymer, preferably, the encapsulating composition includes, by weight: 100 parts of the vinyl polymer; 0.2-3 parts of the diethylene glycol dimethacrylate; and 0.1-2 parts of the organic peroxide, preferably, the polyethylene glycol dimethacrylate is 0.4-2 parts, further preferably 0.6-1.5 parts, and further preferably 0.8-1.2 parts.

On the basis of ensuring that the organic peroxide can decompose and produce enough primary radicals during melt extrusion, so as to initiate a polymerization reaction of the diethylene glycol dimethacrylate, and in order to further improve the storage stability of the organic peroxide, preferably, the one-minute half-life temperature of the organic peroxide is 130-170 °C; and preferably, the organic peroxide is selected from any one or more of tert-butyl peroxyacetate, tert-butylperoxy isopropyl carbonate, tert-butyl peroxy-3,5,5-trimethylhexanoate, tert-butylperoxy 2-ethylhexyl carbonate, tert-amyl peroxybenzoate, tert amyl peroxyacetate, tert-amyl peroxy-3,5,5-trimethylhexanoate, tert-amyl peroxy 2-ethylhexyl carbonate, tert-butyl peroxyisobutyrate, 2,5-dimethyl-2,5-bis(benzoylperoxy)-hexane, benzoyl peroxide, 2,2-di(tert-butylperoxy)butane, 1,1-di(tert-butylperoxy)cyclohexane, 1,1-di-(tert-butylperoxy)-3,3,5-trimethylcyclohexane, 1,1-bis(tert-amylperoxy)cyclohexane and 1,1-di-(tert-amylperoxy)-3,3,5-trimethylcyclohexane.

In an embodiment of the present disclosure, the vinyl polymer is thermoplastic vinyl polymer; and the melting point of the vinyl polymer is 85-125 °C, preferably 90-120 °C, and further preferably 95-115 °C.

When the encapsulating glue film obtained by means of preparation of the encapsulating composition is used for a solar assembly, and if the melting point of the vinyl polymer is too low, the solar assembly is prone to creep during outdoor use, resulting in relative displacement between glass and a cell piece; and if the melting point of the vinyl polymer is too high, the Young modulus of the encapsulating glue film is large, not facilitating the buffer performance of the encapsulating glue film. In the present disclosure, in order to cause the encapsulated solar cell assembly to have the ability to resist thermal creep, the vinyl polymer is used preferably. In addition, the melting point of the vinyl polymer is determined by a maximum melting peak temperature tested by a DSC, and the tested heating rate is 10 °C/min.

In order to further take the ability of the solar cell assembly to resist thermal creep into consideration and avoid hollowing, preferably, the vinyl polymer includes a combination of any one or more of polyethylene, hyperbranched polyethylene and ethylene-$\alpha$ olefin copolymer; preferably, the density of the polyethylene is 0.91-0.93 g/cm$^3$; preferably, the branching degree of the hyperbranched polyethylene is 40-140 branched chains/1000 carbons; and preferably, the ethylene-$\alpha$ olefin copolymer is selected from any one or more ethylene-butene copolymer, ethylene-octene copolymer and ethylene-propylene-hexene copolymer.

In order to improve the adhesion of the encapsulating glue film, preferably, the vinyl polymer further includes a combination of any one or more of ethylene-vinyl acetate, ethylene-methyl methacrylate, ethylene-acrylic acid copolymer, and silane-grafted polyolefin.

Definitely, those skilled in the art may also add, according to actual requirements, any one or more of an antioxidant, a light stabilizer, an ultraviolet absorbent, an anti-coking agent, a plasticizer, an antistatic agent, an anticorrosive agent and an inorganic salt filler in the encapsulating glue film.

A typical implementation of the present disclosure provides a composition, the composition is non-peroxide initiated composition, and includes polyolefin resin and a monomer. The monomer includes a compound shown in a structural formula I:

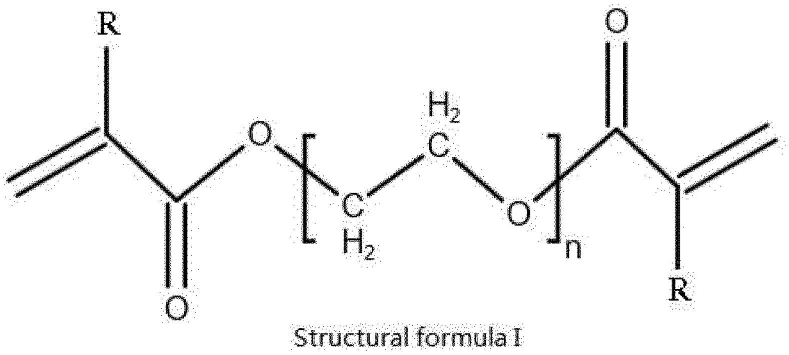

Structural formula I

,

wherein R is H or methyl, and n is an integer of 1-5; and a polymerization mode of the monomer is ultraviolet light initiated polymerization, or radiation initiated polymerization, or microwave initiated polymerization.

The polyolefin resin and the monomer can be uniformly mixed at room temperature. However, when the polyolefin resin is heated and melted, the polar monomer and the non-polar polyolefin resin are thermodynamically incompatible, resulting in certain aggregation of monomer molecules. Meanwhile, the monomer forms a hyperbranched polymer that has several ester groups and ether bonds in situ in the polyolefin resin matrix by means of ultraviolet light initiated polymerization or radiation initiated polymerization, the hyperbranched polymer structure can weaken the mobility of the metal ions or deprive the metal ions of electron conduction, thereby reducing the mobility of the metal ions, so as to improve the dry insulation resistance of the polyolefin resin, in addition, the composition has simple components, readily available raw materials, less process steps, and low costs. If the n is less than 2, the molecular weight of the monomer is too low, resulting in easy precipitation of the monomer in the polyolefin resin matrix, such that the effect of the monomer cannot achieved; and if the n is greater than 5, the viscosity of the monomer is too large, not facilitating mixing processing, and increasing polymerization difficulty.

In order to further improve the dispersivity of the monomer in the polyolefin resin matrix, so as to cause the monomer to better form a polymer structure in situ in the polyolefin resin matrix, preferably, the n is 2-4; preferably, the n is 2-3; and further preferably, the n is 2.

Since a polyolefin material has good light transmission, water resistance and high elasticity, and is non-corrosive, the polyolefin material is ideal for an encapsulating material of an electronic component, in the present disclosure, in order to further improve the performance of the polyolefin material so as to obtain the encapsulating material or master batch having excellent performance, preferably, the composition includes, by weight: 100 parts of the polyolefin resin; and 0.05-5 parts of the monomer; preferably, the monomer is 0.1-3 parts, further preferably 0.2-2 parts, further preferably 0.3-1.5 parts, further preferably 0.4-1.2 parts, and more preferably 0.5-1 parts.

Since the use amount of the monomer is too little, improvement of the volume resistivity of the polyolefin resin is limited; and when the use amount of the monomer is too much, a negative effect of precipitation of an additive is caused. The composition having a relationship of the above parts by weight better facilitates the synergistic effect between the components, such that the performance of the components is achieved more fully, so as to obtain various products such as film products and cables having excellent comprehensive performance.

In order to further improve the synergistic performance between the polyolefin resin and a monomer polymer, so as to improve the dry insulation resistance of the polyolefin resin, preferably, the polyolefin resin includes copolymer of ethylene and $C_{3-20}$ $\alpha$ olefin, preferably, the polyolefin resin is selected from a combination of any one or more of ethylene-propylene copolymer, ethylene-butene copolymer, ethylene-octene copolymer, and ethylene-propylene-octene copolymer; in particular, the encapsulating glue film formed by using the low-melting-point polyolefin resin has better light transmission, which is more suitable to be used as an encapsulating glue film on a front face of a photovoltaic assembly, in order to further improve the light transmission of the encapsulating glue film, preferably, the melting point of the polyolefin resin is 40-85 °C. In addition, if the melt index of the polyolefin resin is lower, the fluidity of the encapsulating glue film during lamination is weaker, which is more unfavorable to the desirable encapsulating of a battery; and if the melt index of the polyolefin resin is higher, the fluidity of the encapsulating glue film during lamination is stronger, which more easily leads to slippage of the cell piece during a lamination process, such that it is detrimental to the maintenance of a photovoltaic assembly structure, in order to take the encapsulating effect of the encapsulating glue film on the entire photovoltaic module into consideration and maintain the stability of the relative positions of layers in the photovoltaic assembly, preferably, the melt index of the polyolefin resin is 3-40 g/10 min, Wherein the melting point of the polyolefin

resin is determined by the melting peak temperature of the DSC.

In order to improve the crosslinking density of the polyolefin resin, preferably, the composition further includes, by weight, 0.1-3 parts of a co-crosslinking agent, preferably, the co-crosslinking agent is a compound that includes at least three double bonds; further preferably, the co-crosslinking agent is the compound having an annular structure; and further preferably, the co-crosslinking agent is triallyl isocyanurate and/or triallyl cyanurate.

In an embodiment of the present disclosure,the composition further includes, by weight, 0.1-1.5 parts of organosiloxane, preferably, the organosiloxane simultaneously includes an olefinic group and a hydrolyzable group; further preferably, the organosiloxane is a trialkoxysilane compound; and further preferably, the trialkoxysilane is selected from a combination of any one or more of γ-methacryloyloxypropyl trimethoxysilane, vinyltrimethoxysilane, triethoxyvinylsilane, vinyl tris(β-methoxyethoxy) silane, and allyltrimethoxysilane.

The organosiloxane is organosiloxane that simultaneously has the olefinic group and the hydrolyzable group, which may improve the interface adhesion of the polyolefin resin. Definitely, those skilled in the art may also add, according to actual requirements, any one or more of an antioxidant, a light stabilizer, an ultraviolet absorbent, an anti-coking agent, a plasticizer, an antistatic agent, an anticorrosive agent and an inorganic salt filler in the composition.

In some embodiments of the present disclosure, preferably, the polyolefin resin in the composition is vinyl polymer, and the monomer is diethylene glycol dimethacrylate, such that the synergistic effect of the polyolefin resin and the diethylene glycol dimethacrylate monomer is further improved, thereby obtaining a hyperbranched polymer which is more beneficial to reducing electronic mobility capability.

In an embodiment of the present disclosure, the vinyl polymer is thermoplastic vinyl polymer; and the melting point of the vinyl polymer is 86-125 °C, preferably 90-120 °C, and further preferably 95-115 °C.

When the encapsulating glue film is obtained by means of preparation of the composition including the vinyl polymer with the above melting point, a crosslinking agent or a co-crosslinking agent does not need to be extra added, such that production time costs are saved while raw material costs are saved. Therefore, the encapsulating glue film may be widely used as an encapsulating glue film on a back face of the photovoltaic assembly.

When the composition is prepared into the encapsulating glue film and the encapsulating glue film is used for the solar assembly, and if the melting point of the vinyl polymer is too low, the solar assembly is prone to creep during outdoor use, resulting in relative displacement between glass and a cell piece; and if the melting point of the vinyl polymer is too high, the Young modulus of the encapsulating glue film is large, not facilitating the buffer performance of the encapsulating glue film. In the present disclosure, in order to cause the encapsulated solar cell assembly to have the ability to resist thermal creep, the vinyl polymer with the above melting point is used preferably. In addition, the melting point of the vinyl polymer is determined by a maximum melting peak temperature tested by a DSC, and the tested heating rate is 10 °C/min.

In order to further take the ability of the solar cell assembly to resist thermal creep into consideration and avoid voids, preferably, the vinyl polymer includes a combination of any one or more of polyethylene, hyperbranched polyethylene and ethylene-α olefin copolymer; preferably, the density of the polyethylene is 0.91-0.93 g/cm$^3$; preferably, the branching degree of the hyperbranched polyethylene is 40-140 branched chains/1000 carbons; and preferably, the ethylene-α olefin copolymer is selected from any one or more ethylene-butene copolymer, ethylene-octene copolymer and ethylene-propylene-hexene copolymer.

In an embodiment of the present disclosure, the vinyl polymer further includes a combination of any one or more of ethylene-vinyl acetate, ethylene-methyl acrylate copolymer, ethylene-acrylic acid copolymer, ethylene-glycidyl methacrylate copolymer, ethylene-acrylate-glycidyl methacrylate copolymer, maleic anhydride-grafted polyolefin, and silane-grafted polyolefin. For example, preferably, the maleic anhydride-grafted polyolefin is a POE grafted by maleic anhydride, and the silane-grafted polyolefin is a POE grafted by vinyltrimethoxysilane.

The adhesion inherent of the ethylene-vinyl acetate, the ethylene-(methyl) acrylate copolymer, the ethylene-acrylic acid copolymer, the ethylene-glycidyl methacrylate copolymer and the ethylene-acrylate-glycidyl methacrylate copolymer is better than the bonding property of the vinyl polymer, since the polyolefin grafted by maleic anhydride or silane is separately introduced with two amphiphilic groups so as to improve the adhesion of the grafted polyolefin, the adhesion of the encapsulating glue film is improved when the composition is prepared to obtain the encapsulating glue film.

Definitely, those skilled in the art may also add, according to actual requirements, any one or more of an antioxidant, a light stabilizer, an ultraviolet absorbent, an anti-coking agent, a plasticizer, an antistatic agent, an anticorrosive agent and an inorganic salt filler in the composition.

In order to obtain various products such as film products and cables, preferably, the shape of the composition is selected from any one of a granule, a flake, a tube, or a strip.

A typical implementation of the present disclosure provides a composition, the composition includes polyolefin resin, and a three-dimensional polymer containing several ester groups and ether bonds, wherein a structural formula of a monomer forming the three-dimensional polymer is represented as:

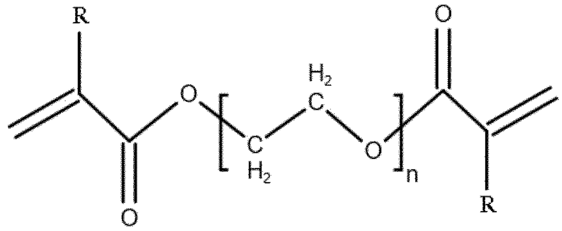

,

wherein n is an integer of 2-5, and R is H or $CH_3$.

The structure of the three-dimensional polymer generally refers to a polymer system which is formed by means of polymerization of a dobby monomer in a three-dimensional space. Since the monomer forming the three-dimensional polymer in the present disclosure contains two olefinic unsaturated bonds, the three-dimensional polymer obtained by means of polymerization of the monomer contains several ether bonds and ester groups. Oxygen atoms in the ether bonds and the ester groups contain lone pair electrons, in addition, by means of the synergistic effect between the two oxygen atoms, the residual metal ions in the polyolefin resin are chelated together, such that the metal ions are weakened or deprived their electron conduction, so as to improve the insulation resistance of the polyolefin resin, in addition, the composition has simple components, readily available raw materials, and low costs.

If the n is less than 2, the ether bonds are absent in a polyester compound, such that the effect of synergistically chelating the metal ions cannot be achieved; and if the n is greater than 5, the molecular weight of the monomer is too large, resulting in a large steric effect, such that the three-dimensional polymer containing several ester groups and ether bonds cannot be formed by means of polymerization.

In an embodiment of the present disclosure, the composition further includes organic peroxide.

The composition including the organic peroxide may initiate, when being heated, the polyolefin resin to undergo a crosslinking reaction, so as to increase the heat resistance of the polyolefin resin.

In order to take the synergistic effect of the ester groups or ether bonds of the three-dimensional polymer and the network or hyperbranched structure of the three-dimensional polymer into consideration, preferably, the n is 2-4; preferably, the n is 2-3; and further preferably, the n is 2.

In an embodiment of the present disclosure, the three-dimensional polymer is a hyperbranched polymer, and the number-average molecular weight of the hyperbranched polymer is 3000-15000.

If the number-average molecular weight of the polymer is lower than 3000, the effect of the formed three-dimensional polymer on chelating the residual metal ions in the polyolefin resin is too weak; if the number-average molecular weight of the polymer is higher than 15000, the distribution of the polymer in the polyolefin resin is uneven, resulting in low overall insulation improvement of the polyolefin resin, such that the three-dimensional polymer in the above number-average molecular weight range is preferred. Wherein, the number-average molecular weight of the three-dimensional polymer may be measured by means of a Gel Permeation Chromatograph (GPC).

A typical method for forming the three-dimensional polymer includes: dissolving, by weight, 30 parts of the monomer into 100 parts of ethanol, and pouring the mixture into a 500 mL round-bottom flask; then adding 0.15-3 parts of a radical initiator (the amount of the radical initiator is 0.5-10% of the monomer), so as to form a mixed solution; placing the flask into an oil bath pan of 60-120 °C, performing stirring, and performing condensation reflux for 1-48 hours; and performing filtration to obtain a white product, and drying the white product to obtain the three-dimensional polymer.

In order to further improving the synergistic performance of the polyolefin resin, the three-dimensional polymer and the organic peroxide, so as to improve the insulation resistance of the polyolefin resin, preferably, the polyolefin resin includes any one or more of homopolymer or copolymer formed by means of coordination polymerization of ethylene, propylene and $C_{4-20}$ $\alpha$ olefin; and preferably, the polyolefin resin is selected from a combination of any one or more of ethylene-propylene copolymer, ethylene-butene copolymer, ethylene-octene copolymer, and ethylene-propylene-octene copolymer.

Since the polyolefin resin has good light transmission, water resistance and high elasticity, and is non-corrosive, the polyolefin resin is ideal for an encapsulating material of an electronic component. In the present disclosure, in order to further improve the performance of the polyolefin material, so as to obtain various products such as film products and cables having excellent comprehensive performance, preferably, the composition includes: 100 parts of the polyolefin resin; 0.1-5 parts of the three-dimensional polymer; and 0.1-2 parts of the organic peroxide, preferably, the three-dimensional polymer is 0.2-3 parts, further preferably 0.3-2.5 parts, further preferably 0.4-2 parts, and more preferably 0.5-1.5 parts. Preferably, the organic peroxide is selected from a combination of any one or more of diacyl peroxide, dialkyl peroxide, peroxide ester and ketal peroxide. Preferably, the peroxide ester is selected from a combination of any one or more of ethyl 3,3-bis(tert-butylperoxy)butyrate, ethyl 3,3-bis(tert-amylperoxy)butyrate, tert-butyl peroxybenzoate, tert-butyl peroxyacetate, tert-butylperoxy isopropyl carbonate, tert-butyl peroxy-3,5,5-trimethylhexanoate, tert-butylperoxy 2-ethylhexyl carbonate, n-butyl 4,4-bis(tert-butylperoxy)valerate, tert-amyl peroxybenzoate, tert amyl peroxyacetate,

tert-amyl peroxy-3,5,5-trimethylhexanoate, tert-amyl peroxy 2-ethylhexyl carbonate, tert amyl peroxyisobutyrate and 2,5-dimethyl-2,5-bis(benzoylperoxy)-hexane. Preferably, the diacyl peroxide is selected from a combination of any one or more of benzoyl peroxide, lauric peroxide and decanoic acid peroxide. Preferably, the ketal peroxide is selected from a combination of any one or more of 2,2-di(tert-butylperoxy)butane, 1,1-di(tert-butylperoxy)cyclohexane, 1,1-di-(tert-butylperoxy)-3,3,5-trimethylcyclohexane, 1,1-bis(tert-amylperoxy)cyclohexane and 1,1-di-(tert-amylperoxy)-3,3,5-trimethylcyclohexane. Preferably, the dialkyl peroxide is diisopropylbenzene peroxide and/or 2,5-dimethyl-2,5-di(tert-butylperoxy)hexane.

The composition having a relationship of the above parts by weight better facilitates the synergistic effect between the components, such that the performance of the components is achieved more fully, so as to obtain various products such as film products and cables having excellent comprehensive performance, if the use amount of the three-dimensional polymer is too little, the volume resistivity of the polyolefin cannot be improved obviously; and if the use amount of the three-dimensional polymer is too much, a negative effect of precipitation of an additive is caused.

In order to further improve the synergistic performance between the polyolefin resin and the three-dimensional polymer and the organic peroxide, so as to facilitate film formation by means of melt extrusion, preferably, the melting point of the polyolefin resin is 40-90 °C, in addition, the encapsulating glue film formed by using the polyolefin resin in the melting point range has better light transmission, which is more suitable to be used as an encapsulating glue film on a front face of a photovoltaic assembly. In addition, if the melt index of the polyolefin resin is lower, the fluidity of the encapsulating glue film during lamination is weaker, which is more unfavorable to the desirable encapsulating of a battery; and if the melt index of the polyolefin resin is higher, the fluidity of the encapsulating glue film during lamination is stronger, which more easily leads to slippage of the cell piece during a lamination process, such that it is detrimental to the maintenance of a photovoltaic assembly structure, in order to take the encapsulating effect of the encapsulating glue film on the entire photovoltaic module into consideration and maintain the stability of the relative positions of layers in the photovoltaic assembly, preferably, the melt index of the polyolefin resin is 3-50 g/10 min. The melting point of the polyolefin resin is determined by the melting peak temperature of the DSC.

In order to improve the crosslinking density of the polyolefin resin, preferably, the composition further includes, by weight, 0.2-3 parts of a co-crosslinking agent, preferably, the co-crosslinking agent is a compound that includes at least three double bonds; further preferably, the co-crosslinking agent is the compound having an annular structure; and further preferably, the co-crosslinking agent is triallyl isocyanurate and/or triallyl cyanurate.

In an embodiment of the present disclosure, the composition further includes, by weight, 0.1-1.5 parts of organosiloxane. Preferably, the organosiloxane simultaneously includes an olefinic group and a hydrolyzable group; further preferably, the organosiloxane is a trialkoxysilane compound; and further preferably, the trialkoxysilane is selected from a combination of any one or more of $\gamma$-methacryloyloxypropyl trimethoxysilane, vinyltrimethoxysilane, triethoxyvinylsilane, vinyl tris($\beta$-methoxyethoxy) silane, and allyltrimethoxysilane.

The organosiloxane is organosiloxane that simultaneously has the olefinic group and the hydrolyzable group, which may improve the interface adhesion of the polyolefin resin.

In order to increase the adhesion of the encapsulating glue film obtained by the composition, some components of which adhesion is better than that of the polyolefin resin are added. Preferably, the polyolefin resin further includes copolymer of ethylene and any one or more of vinyl acetate, acrylate, methacrylate, acrylic acid, glycidyl methacrylate and maleic anhydride; and the mass fraction of the ethylene is greater than 60%.

In an embodiment of the present disclosure, the polyolefin resin further includes vinylsilane-grafted polyolefin. The grafting rate of vinylsilane is 0.1-2%, further, the vinylsilane is preferably vinyltrimethoxysilane.

Since the polyolefin grafted by maleic anhydride or silane is separately introduced with two amphiphilic groups so as to improve the adhesion of the grafted polyolefin, the adhesion of the encapsulating glue film is improved when the composition is prepared to obtain the encapsulating glue film.

In order to obtain various products such as film products and cables, preferably, the shape of the composition is selected from any one of a granule, a flake, a tube, or a strip. Definitely, those skilled in the art may also add, according to actual requirements, any one or more of an antioxidant, a light stabilizer, an ultraviolet absorbent, an anti-coking agent, a plasticizer, an antistatic agent, an anticorrosive agent and an inorganic salt filler in the composition.

Another typical implementation of the present disclosure provides an encapsulating glue film, which is obtained by mixing and performing melt extrusion on components in a composition, the composition is the foregoing encapsulating composition, or the composition is the foregoing composition.

The encapsulating glue film obtained by using a composition has high volume resistivity. In order to further improve the synthesis efficiency of the encapsulating glue film, preferably, the components in the composition are weighed in proportion and are uniformly mixed by means of mixing devices such as a helical-ribbon material-mixing kettle, an internal mixer and a twin-screw extruder, and finally, dried particles are formed; and then the dried particles are melted and plastified by means of the screw extruder, and extrusion and film forming are performed by means of a coat-hanger T-shaped die head, so as to obtain the encapsulating glue film. Specifically, for example, extrusion is performed by means of one screw extruder, and a single-layer glue film is formed by means of casting of a T-shaped

die head; then extrusion is performed by means of a patterned roll and a rubber roll, such that a pattern is formed on the surface of the single-layer glue film; then cooling and traction are performed by means of a plurality of metal rolls; and the single-layer glue film is finally rolled into a roll, alternatively, extrusion is performed by means of two or more screw extruders together, and at least one of the screw extruders is used for extruding the encapsulating composition provided in the present disclosure. Materials extruded by a plurality of screw extruders are casted to form a multi-layer co-extrusion encapsulating glue film by means of the same T-shaped die head; then extrusion is performed by means of a patterned roll and a rubber roll, such that a pattern is formed on the surface of the multi-layer encapsulating glue film; then cooling and traction are performed by means of a plurality of metal rolls; and the multi-layer encapsulating glue film is finally rolled into a roll. Definitely, those skilled in the art may also carry out the synthesis of the encapsulating glue film with reference to a conventional technical means in the related art, and details are not described herein again.

In an embodiment of the present disclosure, a method for preparing the encapsulating glue film by using vinyl polymer, organic peroxide and diethylene glycol dimethacrylate of the encapsulating composition as raw materials includes: S1, mixing the vinyl polymer, the organic peroxide and the diethylene glycol dimethacrylate, so as to obtain a mixture; and S2, performing melt extrusion on the mixture, so as to obtain the encapsulating glue film. The temperature of melt extrusion is 120-150 °C, the one-minute half-life temperature of the organic peroxide is less than or equal to 170 °C, and preferably, the rotary speed of the mixture at a melt extrusion phase is 10-40 rpm/min.

During melt extrusion, the diethylene glycol dimethacrylate and the polyolefin material are easily aggregated due to a large difference in polarity, then primary radicals produced by means of thermal decomposition of the organic peroxide make the gathered polyethylene glycol dimethacrylate rapidly undergo a radical polymerization reaction, such that a polymer network structure that has a three-dimensional network structure and that has several ester groups and ether bonds is formed in situ in diethylene glycol dimethacrylate, the polymer network structure can adsorb residual metal ions in the polyolefin resin, thereby reducing the mobility of the metal ions, so as to improve the dry insulation resistance of the polyolefin resin. Since the one-minute half-life temperature of the organic peroxide is less than or equal to 170 °C, the organic peroxide can decompose and produce enough primary radicals during melt extrusion, so as to initiate a polymerization reaction of the diethylene glycol dimethacrylate, such that the diethylene glycol dimethacrylate is polymerized into a network structure as much as possible. In addition, at the temperature of melt extrusion, the vinyl polymer does not participate in the reaction, such that the polymer network of the diethylene glycol dimethacrylate is not damaged. In addition, the method for preparing the encapsulating glue film is simple, and has readily available raw materials and low costs.

In order to control the diethylene glycol dimethacrylate to not be dispersed by excessive shearing to affect the undergoing of the polymerization reaction, and control the retention time of the mixture at the melt extrusion phase to be 1-4 min, so as to cause the reaction to be fully undergone, preferably, the rotary speed of the mixture at a melt extrusion phase is 10-40 rpm/min.

In an embodiment of the present disclosure, a method for preparing the encapsulating glue film by using vinyl polymer and diethylene glycol dimethacrylate of the composition as raw materials includes: S1, mixing the vinyl polymer and the diethylene glycol dimethacrylate, so as to obtain a mixture; S2, performing melt extrusion on the mixture, so as to obtain an extruded film; and S3, performing ultraviolet light irradiation or radiation on the extruded film, so as to obtain the encapsulating glue film, preferably, radiation is selected from any one or more of $\alpha$-ray radiation, $\beta$-ray radiation, $\gamma$-ray radiation and X-ray radiation, and more preferably, a radiation dosage absorbed by the extruded film is 1-100 KGy.

Performing ultraviolet light irradiation or radiation on the extruded film facilitates in-situ polymerization of the diethylene glycol dimethacrylate in the vinyl polymer, and the vinyl polymer is also cross-linked to a certain extent, so as to obtain the thermosetting encapsulating glue film. In addition, the method for preparing the encapsulating glue film is simple, and has readily available raw materials and low costs. In addition, in order to further improve the efficiency of radiation, preferably, radiation is selected from any one or more of $\alpha$-ray radiation, $\beta$-ray radiation, $\gamma$-ray radiation and X-ray radiation, and more preferably, a radiation dosage absorbed by the extruded film is 1-100 KGy.

In order to further adapt market requirements, preferably, the encapsulating glue film is a single-layer encapsulating glue film or a multi-layer co-extrusion encapsulating glue film.

In an embodiment of the present disclosure, the encapsulating glue film includes vinyl polymer and polyethylene glycol dimethacrylate.

Since polyethylene glycol dimethacrylate in the encapsulating glue film is a polymer network structure that has a three-dimensional network structure and that has several ester groups and ether bonds, the polymer network structure can adsorb residual metal ions in the vinyl polymer, thereby reducing the mobility of the metal ions, so as to improve the dry insulation resistance of the vinyl polymer. In addition, the method for preparing the encapsulating glue film is simple, and has readily available raw materials and low costs.

In order to further improve the adsorption efficiency of the network structure of the polyethylene glycol dimethacrylate for the residual metal ions in the polyolefin resin, preferably, a mass ratio of the vinyl polymer to the polyethylene glycol dimethacrylate is 100:0.2-3, preferably 100:0.4-2, further preferably 100:0.6-1.5, and more preferably 100:0.8-1.2.

In order to better control the network structure of the polyethylene glycol dimethacrylate, preferably, the number-average molecular weight of the polyethylene glycol dimethacrylate is 500-3000. If the number-average molecular weight is lower than 500, the density of the network of the formed polyethylene glycol dimethacrylate is too low, resulting in weak adsorption effect on the metal ions, such that the polymer network structure cannot well adsorb the residual metal ions in the vinyl polymer; and if the number-average molecular weight is higher than 3000, the metal ions are easily precipitated from the vinyl polymer, such that the effect of adsorbing the residual metal ions in the vinyl polymer is reduced.

In an embodiment of the present disclosure, the vinyl polymer is thermoplastic vinyl polymer; and the melting point of the vinyl polymer is 85-125 °C, preferably 90-120 °C, and further preferably 95-115 °C.

When the encapsulating glue film is used for a solar assembly, and if the melting point of the vinyl polymer is too low, the solar assembly is prone to creep during outdoor use, resulting in relative displacement between glass and a cell piece; and if the melting point of the vinyl polymer is too high, the Young modulus of the encapsulating glue film is large, not facilitating the buffer performance of the encapsulating glue film. In the present disclosure, in order to cause the encapsulated solar cell assembly to have the ability to resist thermal creep, the vinyl polymer is used preferably. In addition, the melting point of the vinyl polymer is determined by a maximum melting peak temperature tested by a DSC, and the tested heating rate is 10 °C/min.

If equilibrium torsion of the vinyl polymer is too low, it indicates that the molecular weight of the encapsulating glue film is too low, such that the encapsulating glue film easily flows at a high temperature, and is adverse to be used by the solar assembly at the high temperature. If the equilibrium torsion of the vinyl polymer is too high, it indicates that the molecular weight of the encapsulating glue film is too high, and during assembly lamination, fluidity is relatively poor, such that gaps in the solar assembly cannot be filled with the polyolefin, resulting in voids. In order to avoid the occurrence of the above phenomenon, preferably, the equilibrium torsion of the vinyl polymer at 140°C is 0.1-0.3 dN-m. In addition, the equilibrium torsion of the vinyl polymer is tested at 140 °C by using a rotorless vulcanizer.

In order to further take the ability of the solar cell assembly to resist thermal creep into consideration and avoid hollowing, preferably, the vinyl polymer includes a combination of any one or more of polyethylene, hyperbranched polyethylene and ethylene-$\alpha$ olefin copolymer; preferably, the density of the polyethylene is 0.91-0.93 g/cm$^3$; preferably, the branching degree of the hyperbranched polyethylene is 40-140 branched chains/1000 carbons; and preferably, the ethylene-$\alpha$ olefin copolymer is selected from any one or more ethylene-butene copolymer, ethylene-octene copolymer and ethylene-propylene-hexene copolymer.

In order to improve the adhesion of the encapsulating glue film, preferably, the vinyl polymer further includes a combination of any one or more of ethylene-vinyl acetate, ethylene-methyl methacrylate, ethylene-acrylic acid copolymer, and silane-grafted polyolefin.

Definitely, those skilled in the art may also add, according to actual requirements, any one or more of an antioxidant, a light stabilizer, an ultraviolet absorbent, an anti-coking agent, a plasticizer, an antistatic agent, an anticorrosive agent and an inorganic salt filler in the encapsulating glue film.

Another typical implementation of the present disclosure provides an electronic component. The electronic component includes any one of a solar cell, a liquid crystal panel, an electroluminescent device, a plasma display device or a touch screen. At least one surface of the electronic component is in contact with an encapsulating glue film; and the encapsulating glue film is the foregoing encapsulating glue film.

The encapsulating glue film of the present disclosure is used for the electronic component, such as a solar cell, a liquid crystal panel, an electroluminescent device, a plasma display device or a touch screen. At least one surface of the electronic component is snugly contact with the encapsulating glue film provided in the present disclosure, and the outermost side is glass or other hard or soft polymer substrates. The above are formed as a whole after internal gas is removed by means of vacuum hot pressing. By means of the encapsulating material provided in the present disclosure, leakage current is reduced after vacuum hot pressing, such that the safety of the electronic component at high voltages is guaranteed. According to actual requirements, a single-layer encapsulating glue film encapsulated electronic component or a multi-layer encapsulating glue film encapsulated electronic component may be obtained by means of preparation.

Still another typical implementation of the present disclosure provides a solar cell assembly, the solar cell assembly includes a solar cell. At least one surface of the solar cell is in contact with an encapsulating glue film; and the encapsulating glue film is the foregoing encapsulating glue film.

By means of the encapsulating material provided in the present disclosure, leakage current is reduced after vacuum hot pressing, such that the safety of the solar cell assembly at high voltages is guaranteed. According to actual requirements, a single-layer encapsulating glue film encapsulated solar cell assembly or a multi-layer encapsulating glue film encapsulated solar cell assembly may be obtained by means of preparation.

The beneficial effects of the present disclosure are further described below with reference to the specific embodiments and comparative examples.

Embodiment 1

0.1 parts of diethylene glycol dimethacrylate (2DEGDMA), 0.7 parts of tert-butylperoxy 2-ethylhexyl carbonate (TBEC), 0.7 parts of a co-crosslinking agent triallyl isocyanurate (TAIC) and 0.3 parts of a thickening agent γ-methacryloyloxypropyl trimethoxysilane (KH570) were weighed; the four substances were uniformly mixed, then added to 100 parts of ethylene-octene copolymer (DOW Engage 8411, a melting point being 55°C, and a melt index being 18 g/10 min) POE particles, and stirred, until the surfaces of the POE particles were dried. The dried POE particles were added to a single-screw extruder, and the temperature of the extruder was 80 °C; a uniform POE melt was formed by means of a melting and shearing effect of a screw; a film was extruded by means of a wide-slot nozzle, and the temperature of a die head was 100 °C; by means of the extrusion effect of a knurling roll and a rubber roll, a texture structure was formed on the surface of the film; then cooling was performed by means of a plurality of cooling rolls; and finally, rolling-up was performed by means of a wind-up roll, so as to obtain the film with the thickness being 0.5 mm.

Embodiment 2

The difference between Embodiment 2 and Embodiment 1 lied in that, the polyethylene glycol dimethacrylate was triethylene glycol dimethacrylate (3EGDMA), and the film with the thickness being 0.5 mm was finally obtained.

Embodiment 3

The difference between Embodiment 3 and Embodiment 1 lied in that, the polyethylene glycol dimethacrylate was tetraethylene glycol dimethacrylate (4EGDMA), and the film with the thickness being 0.5 mm was finally obtained.

Embodiment 4

The difference between Embodiment 4 and Embodiment 1 lied in that, the polyethylene glycol dimethacrylate was pentaethylene glycol dimethacrylate (5EGDMA), and the film with the thickness being 0.5 mm was finally obtained.

Embodiment 5

The difference between Embodiment 5 and Embodiment 1 lied in that, the 2DEGDMA was 3 parts by weight, and the film with the thickness being 0.5 mm was finally obtained.

Embodiment 6

The difference between Embodiment 6 and Embodiment 1 lied in that, the 2DEGDMA was 0.15 parts by weight, and the film with the thickness being 0.5 mm was finally obtained.

Embodiment 7

The difference between Embodiment 7 and Embodiment 1 lied in that, the 2DEGDMA was 2.5 parts by weight, and the film with the thickness being 0.5 mm was finally obtained.

Embodiment 8

The difference between Embodiment 8 and Embodiment 1 lied in that, the 2DEGDMA was 0.2 parts by weight, and the film with the thickness being 0.5 mm was finally obtained.

Embodiment 9

The difference between Embodiment 9 and Embodiment 1 lied in that, the 2DEGDMA was 2 parts by weight, and the film with the thickness being 0.5 mm was finally obtained.

Embodiment 10

The difference between Embodiment 10 and Embodiment 1 lied in that, the 2DEGDMA was 0.3 parts by weight, and the film with the thickness being 0.5 mm was finally obtained.

Embodiment 11

The difference between Embodiment 11 and Embodiment 1 lied in that, the 2DEGDMA was 1.5 parts by weight, and the film with the thickness being 0.5 mm was finally obtained.

Embodiment 12

The difference between Embodiment 12 and Embodiment 1 lied in that, the 2DEGDMA was 0.5 parts by weight, and the film with the thickness being 0.5 mm was finally obtained.

Embodiment 13

The difference between Embodiment 13 and Embodiment 1 lied in that, the 2DEGDMA was 0.7 parts by weight, and the film with the thickness being 0.5 mm was finally obtained.

Embodiment 14

The difference between Embodiment 14 and Embodiment 1 lied in that, the 2DEGDMA was 1.2 parts by weight, and the film with the thickness being 0.5 mm was finally obtained.

Embodiment 15

The difference between Embodiment 15 and Embodiment 13 lied in that, the TBEC was 0.5 parts by weight, a mass ratio of the 2DEGDMA to the TBEC was 1.4:1, and the film with the thickness being 0.5 mm was finally obtained.

Embodiment 16

The difference between Embodiment 16 and Embodiment 13 lied in that, the TBEC was 2 parts by weight, the mass ratio of the 2DEGDMA to the TBEC was 0.35:1, and the film with the thickness being 0.5 mm was finally obtained.

Embodiment 17

The difference between Embodiment 17 and Embodiment 13 lied in that, the TBEC was 0.4 parts by weight, the mass ratio of the 2DEGDMAto the TBEC was 7:1, and the film with the thickness being 0.5 mm was finally obtained.

Embodiment 18

The difference between Embodiment 18 and Embodiment 1 lied in that, the organic peroxide was 2,5-dimethyl-2,5-bis(benzoylperoxy)-hexane, and the film with the thickness being 0.5 mm was finally obtained.

Embodiment 19

The difference between Embodiment 19 and Embodiment 1 lied in that, the polyolefin resin was MitsuiTAFMERDF740, and the film with the thickness being 0.5 mm was finally obtained, wherein the melting point of the MitsuiTAFMERDF740 was 50°C, and the melt index was 3.5 g/10 min.

Embodiment 20

The difference between Embodiment 20 and Embodiment 1 lied in that, the polyolefin resin was LGLF775, and the film with the thickness being 0.5 mm was finally obtained, wherein the melting point of the LGLF775 was 70°C, and the melt index was 18 g/10 min.

Embodiment 21

The difference between Embodiment 21 and Embodiment 1 lied in that, the co-crosslinking agent was triallyl cyanurate, and the film with the thickness being 0.5 mm was finally obtained.

Embodiment 22

The difference between Embodiment 22 and Embodiment 1 lied in that, the organosiloxane was triethoxyvinylsilane (A151), and the film with the thickness being 0.5 mm was finally obtained.

Embodiment 23

0.1 parts of 1,1-di-(tert-butylperoxy)-3,3,5-trimethylcyclohexane (a one-minute half-life temperature being 153°C) and 1 part of diethylene glycol dimethacrylate (a mass ratio of the diethylene glycol dimethacrylate to the 1,1-di-(tert-butylperoxy)-3,3,5-trimethylcyclohexane being 10:1) were weighed; the two substances were uniformly mixed, then added to mixed particles of 50 parts of ethylene-octene copolymer (DOW Engage 8402) and 50 parts of ethylene-octene copolymer (DOW Engage 8200) and stirred, until the surfaces of the particles were dried. The dried particles were added to a single-screw extruder with an aspect ratio being 32, wherein the temperature of a reaction section of the extruder was set to 140°C, and the rotary speed of a screw was 25 rpm/min. The vinyl polymer particles were formed into a uniform POE melt by means of a melting and shearing effect of the screw, and a polymer network of the diethylene glycol dimethacrylate was formed in situ in the melt, and then a film was extruded by means of a wide-slot nozzle. By means of the extrusion effect of a knurling roll and a rubber roll, a texture structure was formed on the surface of the film; then cooling was performed by means of a plurality of cooling rolls; and finally, rolling-up was performed by means of a wind-up roll, so as to obtain the encapsulating glue film with the thickness being 0.5 mm. The melting point of the encapsulating glue film was 97°C, and the equilibrium torsion at 140 °C was 0.2 dN-m, the mass ratio of the ethylene-octene copolymer in the encapsulating glue film to the polyethylene glycol dimethacrylate was 100:1.0, and the number-average molecular weight of the polyethylene glycol dimethacrylate was 1500.

Embodiment 24

The difference between Embodiment 24 and Embodiment 23 lied in that, the vinyl polymer was a mixture of 30 parts of low-density polyethylene (2426K, and the density being 3 g/$cm^3$) and 70 parts of ethylene-octene copolymer (Engage 8400). The encapsulating glue film with the thickness being 0.5 mm was finally obtained, wherein the melting point of the encapsulating glue film was 115 °C, and the equilibrium torsion at 140 °C was 0.3 dN-m.

Embodiment 25

The difference between Embodiment 25 and Embodiment 23 lied in that, the vinyl polymer was ethylene-octene copolymer (Engage 8411), the encapsulating glue film with the thickness being 0.5 mm was finally obtained, wherein the melting point of the encapsulating glue film was 85°C, and the equilibrium torsion at 140°C was 0.10 dN-m.

Embodiment 26

The difference between Embodiment 26 and Embodiment 23 lied in that, the vinyl polymer was hyperbranched polymer (a branching degree being 60 branched chains/1000 carbons), the encapsulating glue film with the thickness being 0.5 mm was finally obtained, wherein the melting point of the encapsulating glue film was 120 °C, and the equilibrium torsion at 140 °C was 0.25 dN-m.

Embodiment 27

The difference between Embodiment 27 and Embodiment 23 lied in that, the vinyl polymer was 60 parts of ethylene-octene copolymer (Engage 8402) and 40 parts of ethylene-butene copolymer (Tafmer DF740), the encapsulating glue film with the thickness being 0.5 mm was finally obtained, wherein the melting point of the encapsulating glue film was 90°C, and the equilibrium torsion at 140 °C was 0.2 dN m.

Embodiment 28

The difference between Embodiment 28 and Embodiment 23 lied in that, the vinyl polymer was 40 parts of low-density polyethylene (2426K) and 60 parts of ethylene-butene copolymer (Tafmer DF7350), the encapsulating glue film with the thickness being 0.5 mm was finally obtained, wherein the melting point of the encapsulating glue film was 125°C, and the equilibrium torsion at 140 °C was 0.2 dN-m.

Embodiment 29

The difference between Embodiment 29 and Embodiment 23 lied in that, the organic peroxide was tert-butylperoxy 2-ethylhexyl carbonate (a one-minute half-life temperature being 166 °C), and the encapsulating glue film with the thickness being 0.5 mm was finally obtained.

Embodiment 30

The difference between Embodiment 30 and Embodiment 23 lied in that, the organic peroxide was tert-amyl peroxy 2-ethylhexyl carbonate (a one-minute half-life temperature being 155°C), and the encapsulating glue film with the thickness being 0.5 mm was finally obtained.

Embodiment 31

The difference between Embodiment 31 and Embodiment 23 lied in that, the organic peroxide was tert-butyl peroxy-2-ethylhexanoate (a one-minute half-life temperature being 130 °C), and the encapsulating glue film with the thickness being 0.5 mm was finally obtained.

Embodiment 32

The difference between Embodiment 32 and Embodiment 23 lied in that, the organic peroxide was tert-butyl peroxyisobutyrate (a one-minute half-life temperature being 146 °C), and the encapsulating glue film with the thickness being 0.5 mm was finally obtained.

Embodiment 33

The difference between Embodiment 33 and Embodiment 23 lied in that, the organic peroxide was tert-butyl peroxybenzoate (a one-minute half-life temperature being 170°C), and the encapsulating glue film with the thickness being 0.5 mm was finally obtained.

Embodiment 34

The difference between Embodiment 34 and Embodiment 23 lied in that, the temperature of melt extrusion was 120 °C, and the encapsulating glue film with the thickness being 0.5 mm was finally obtained.

Embodiment 35

The difference between Embodiment 35 and Embodiment 23 lied in that, the temperature of melt extrusion was 150 °C, and the encapsulating glue film with the thickness being 0.5 mm was finally obtained.

Embodiment 36

The difference between Embodiment 36 and Embodiment 23 lied in that, 1 part of the diethylene glycol dimethacrylate was weighed, and the mass ratio of the diethylene glycol dimethacrylate to the 1,1-di-(tert-butylperoxy)-3,3,5-trimethylcyclohexane was 7:1, and the encapsulating glue film with the thickness being 0.5 mm was finally obtained.

Embodiment 37

The difference between Embodiment 37 and Embodiment 23 lied in that, 1 part of the diethylene glycol dimethacrylate was weighed, and the mass ratio of the diethylene glycol dimethacrylate to the 1,1-di-(tert-butylperoxy)-3,3,5-trimethylcyclohexane was 12:1, and the encapsulating glue film with the thickness being 0.5 mm was finally obtained.

Embodiment 38

The difference between Embodiment 38 and Embodiment 23 lied in that, 1 part of the diethylene glycol dimethacrylate was weighed, and the mass ratio of the diethylene glycol dimethacrylate to the 1,1-di-(tert-butylperoxy)-3,3,5-trimethylcyclohexane was 5:1, and the encapsulating glue film with the thickness being 0.5 mm was finally obtained.

Embodiment 39

The difference between Embodiment 39 and Embodiment 23 lied in that, 1 part of the diethylene glycol dimethacrylate was weighed, and the mass ratio of the diethylene glycol dimethacrylate to the 1,1-di-(tert-butylperoxy)-3,3,5-trimethylcyclohexane was 15:1, and the encapsulating glue film with the thickness being 0.5 mm was finally obtained.

Embodiment 40

The difference between Embodiment 40 and Embodiment 23 lied in that, 1 part of the diethylene glycol dimethacrylate was weighed, and the mass ratio of the diethylene glycol dimethacrylate to the 1,1-di-(tert-butylperoxy)-3,3,5-trimethylcyclohexane was 3:1, and the encapsulating glue film with the thickness being 0.5 mm was finally obtained.

Embodiment 41

The difference between Embodiment 41 and Embodiment 23 lied in that, 1 part of the diethylene glycol dimethacrylate was weighed, and the mass ratio of the diethylene glycol dimethacrylate to the 1,1-di-(tert-butylperoxy)-3,3,5-trimethylcyclohexane was 20:1, and the encapsulating glue film with the thickness being 0.5 mm was finally obtained.

Embodiment 42

The difference between Embodiment 42 and Embodiment 23 lied in that, 1 part of the diethylene glycol dimethacrylate was weighed, and the mass ratio of the diethylene glycol dimethacrylate to the 1,1-di-(tert-butylperoxy)-3,3,5-trimethylcyclohexane was 25:1, and the film with the thickness being 0.5 mm was finally obtained.

Embodiment 43

The difference between Embodiment 43 and Embodiment 23 lied in that, 50 parts of the ethylene-octene copolymer (DOW Engage 8402), 50 parts of the ethylene-octene copolymer (DOW Engage 8200) and 0.8 parts of the diethylene glycol dimethacrylate were weighed, and the encapsulating glue film with the thickness being 0.5 mm was finally obtained.

Embodiment 44

The difference between Embodiment 44 and Embodiment 23 lied in that, 50 parts of the ethylene-octene copolymer (DOW Engage 8402), 50 parts of the ethylene-octene copolymer (DOW Engage 8200) and 1.2 parts of the diethylene glycol dimethacrylate were weighed, and the encapsulating glue film with the thickness being 0.5 mm was finally obtained.

Embodiment 45

The difference between Embodiment 45 and Embodiment 23 lied in that, 50 parts of the ethylene-octene copolymer (DOW Engage 8402), 50 parts of the ethylene-octene copolymer (DOW Engage 8200) and 1.5 parts of the diethylene glycol dimethacrylate were weighed, and the encapsulating glue film with the thickness being 0.5 mm was finally obtained.

Embodiment 46

The difference between Embodiment 46 and Embodiment 23 lied in that, 50 parts of the ethylene-octene copolymer (DOW Engage 8402), 50 parts of the ethylene-octene copolymer (DOW Engage 8200) and 0.6 parts of the diethylene glycol dimethacrylate were weighed, and the encapsulating glue film with the thickness being 0.5 mm was finally obtained.

Embodiment 47

The difference between Embodiment 47 and Embodiment 23 lied in that, 50 parts of the ethylene-octene copolymer (DOW Engage 8402), 50 parts of the ethylene-octene copolymer (DOW Engage 8200) and 0.4 parts of the diethylene glycol dimethacrylate were weighed, and the encapsulating glue film with the thickness being 0.5 mm was finally obtained.

Embodiment 48

The difference between Embodiment 48 and Embodiment 23 lied in that, 50 parts of the ethylene-octene copolymer (DOW Engage 8402), 50 parts of the ethylene-octene copolymer (DOW Engage 8200) and 2 parts of the diethylene glycol dimethacrylate were weighed, and the encapsulating glue film with the thickness being 0.5 mm was finally obtained.

Embodiment 49

The difference between Embodiment 49 and Embodiment 23 lied in that, 50 parts of the ethylene-octene copolymer (DOW Engage 8402), 50 parts of the ethylene-octene copolymer (DOW Engage 8200) and 0.2 parts of the diethylene glycol dimethacrylate were weighed, and the encapsulating glue film with the thickness being 0.5 mm was finally obtained.

Embodiment 50

The difference between Embodiment 50 and Embodiment 23 lied in that, 50 parts of the ethylene-octene copolymer (DOW Engage 8402), 50 parts of the ethylene-octene copolymer (DOW Engage 8200) and 3 parts of the diethylene glycol dimethacrylate were weighed, and the encapsulating glue film with the thickness being 0.5 mm was finally obtained.

Embodiment 51

The difference between Embodiment 51 and Embodiment 23 lied in that, the vinyl polymer further includes, by weight, 10 parts of ethylene-vinyl acetate, and the encapsulating glue film with the thickness being 0.5 mm was finally obtained.

Embodiment 52

The difference between Embodiment 52 and Embodiment 23 lied in that, the rotary speed of the screw was 10 rpm/min, and the encapsulating glue film with the thickness being 0.5 mm was finally obtained.

Embodiment 53

The difference between Embodiment 53 and Embodiment 23 lied in that, the rotary speed of the screw was 40 rpm/min, and the encapsulating glue film with the thickness being 0.5 mm was finally obtained.

Embodiment 54

The difference between Embodiment 54 and Embodiment 1 lied in that, the rotary speed of the screw was 80 rpm/min, and the encapsulating glue film with the thickness being 0.5 mm was finally obtained.

Embodiment 55

0.8 parts of diethylene glycol dimethacrylate (2EGDMA), 0.7 parts of the co-crosslinking agent triallyl isocyanurate (TAIC) and 0.3 parts of a thickening agent γ-methacryloyloxypropyl trimethoxysilane (KH570) were weighed; the three substances were uniformly mixed, then added to 100 parts of ethylene-octene copolymer (DOW Engage 8411, a melting point being 76 °C, and a melt index being 18 g/10 min) POE particles, and stirred, until the 2EGDMA enters the POE particles, so as to dry the surfaces of the POE particles. The dried POE particles were added to the single-screw extruder, and the temperature of the extruder was 80°C; a uniform POE melt was formed by means of the melting and shearing effect of the screw; an extruded film was obtained by means of extrusion of a coat-hanger die head, and the temperature of the die head was 100 °C; by means of the extrusion effect of a knurling roll and a rubber roll, a texture structure was formed on the surface of the film; then cooling was performed by means of a plurality of cooling rolls; and finally, rolling-up was performed by means of a wind-up roll, so as to obtain a primary film. Then the primary film was radiated by using a β ray, and a radiation dosage absorbed by the primary film was 25 KGy. A film with the thickness being 0.5 mm was obtained finally.

Embodiment 56

The difference between Embodiment 56 and Embodiment 55 lied in that, the monomer was triethylene glycol dimethacrylate (3EGDMA), and the film with the thickness being 0.5 mm was finally obtained.

Embodiment 57

The difference between Embodiment 57 and Embodiment 55 lied in that, the monomer was tetraethylene glycol dimethacrylate (4EGDMA), and the film with the thickness being 0.5 mm was finally obtained.

Embodiment 58

The difference between Embodiment 58 and Embodiment 55 lied in that, the monomer was pentaethylene glycol dimethacrylate (5EGDMA), and the film with the thickness being 0.5 mm was finally obtained.

Embodiment 59

The difference between Embodiment 59 and Embodiment 55 lied in that, the 2EGDMA was 0.05 parts by weight, and the film with the thickness being 0.5 mm was finally obtained.

Embodiment 60

The difference between Embodiment 60 and Embodiment 55 lied in that, the 2EGDMA was 5 parts by weight, and the film with the thickness being 0.5 mm was finally obtained.

Embodiment 61

The difference between Embodiment 61 and Embodiment 55 lied in that, the 2EGDMA was 0.1 parts by weight, and the film with the thickness being 0.5 mm was finally obtained.

Embodiment 62

The difference between Embodiment 62 and Embodiment 55 lied in that, the 2EGDMA was 3 parts by weight, and the film with the thickness being 0.5 mm was finally obtained.

Embodiment 63

The difference between Embodiment 63 and Embodiment 55 lied in that, the 2EGDMA was 2 parts by weight, and the film with the thickness being 0.5 mm was finally obtained.

Embodiment 64

The difference between Embodiment 64 and Embodiment 55 lied in that, the 2EGDMA was 0.2 parts by weight, and the film with the thickness being 0.5 mm was finally obtained.

Embodiment 65

The difference between Embodiment 65 and Embodiment 55 lied in that, the 2EGDMA was 1.5 parts by weight, and the film with the thickness being 0.5 mm was finally obtained.

Embodiment 66

The difference between Embodiment 66 and Embodiment 55 lied in that, the 2EGDMA was 0.3 parts by weight, and the film with the thickness being 0.5 mm was finally obtained.

Embodiment 67

The difference between Embodiment 67 and Embodiment 55 lied in that, the 2EGDMA was 1.2 parts by weight,

and the film with the thickness being 0.5 mm was finally obtained.

Embodiment 68

The difference between Embodiment 68 and Embodiment 55 lied in that, the 2EGDMA was 0.4 parts by weight, and the film with the thickness being 0.5 mm was finally obtained.

Embodiment 69

The difference between Embodiment 69 and Embodiment 55 lied in that, the 2EGDMA was 1.0 parts by weight, and the film with the thickness being 0.5 mm was finally obtained.

Embodiment 70

The difference between Embodiment 70 and Embodiment 55 lied in that, the 2EGDMA was 0.5 parts by weight, and the film with the thickness being 0.5 mm was finally obtained.

Embodiment 71

The difference between Embodiment 71 and Embodiment 55 lied in that, the polyolefin resin was Mitsui TAFMER DF7350, and the film with the thickness being 0.5 mm was finally obtained, wherein the melting point of the Mitsui TAFMER DF7350 was 55°C, and the melt index was 35 g/10 min.

Embodiment 72

The difference between Embodiment 72 and Embodiment 55 lied in that, the polyolefin resin was Borealis Queo 7007LA, and the film with the thickness being 0.5 mm was finally obtained, wherein the melting point of the 7007LA was 48°C, and the melt index was 6.6 g/10 min.

Embodiment 73

The difference between Embodiment 73 and Embodiment 55 lied in that, the co-crosslinking agent was triallyl cyanurate, and the film with the thickness being 0.5 mm was finally obtained.

Embodiment 74

The difference between Embodiment 74 and Embodiment 55 lied in that, the organosiloxane was triethoxyvinylsilane (A151), and the film with the thickness being 0.5 mm was finally obtained.

Embodiment 75

1 part of the diethylene glycol dimethacrylate and 0.3 parts of a thickening agent γ-methacryloyloxypropyl trimethoxysilane (KH570) are weighed; the two substances are uniformly mixed, then added to mixed particles of 50 parts of the ethylene-octene copolymer (DOW Engage 8402) and 50 parts of the ethylene-octene copolymer (DOW Engage 8200), and stirred, until the 2EGDMA enters the particles, so as to dry the surfaces of the particles. The dried particles are added to the single-screw extruder with the aspect ratio being 38, where the temperature of a melting section of the extruder is set to 140°C, and the rotary speed of the screw is 50 rpm/min. The vinyl polymer particles are formed into the uniform POE melt by means of the melting and shearing effect of the screw, and then the extruded film is extruded by means of a coat-hanger die head. By means of the extrusion effect of a knurling roll and a rubber roll, a texture structure is formed on the surface of the film; the extruded film is radiated by using the β ray, and a radiation dosage absorbed by the extruded film is 25 KGy; then cooling is performed by means of a plurality of cooling rolls; and finally, rolling-up is performed by means of a wind-up roll, so as to obtain the encapsulating glue film with the thickness being 0.5 mm, where the melting point of the encapsulating glue film is 97°C, and the equilibrium torsion at 140°C is 0.2 dN-m.

Embodiment 76

The difference between Embodiment 76 and Embodiment 75 lied in that, the vinyl polymer was a mixture of

30 parts of the low-density polyethylene (2426K) and 70 parts of the ethylene-octene copolymer (Engage 8400). The encapsulating glue film with the thickness being 0.5 mm was finally obtained, wherein the melting point of the encapsulating glue film was 105 °C, and the equilibrium torsion at 140 °C was 0.3 dN-m.

Embodiment 77

The difference between Embodiment 77 and Embodiment 75 lied in that, the vinyl polymer was ethylene-octene copolymer (Engage 8450), the encapsulating glue film with the thickness being 0.5 mm was finally obtained, wherein the melting point of the encapsulating glue film was 97°C, and the equilibrium torsion at 140 °C was 0.5 dN m.

Embodiment 78

The difference between Embodiment 78 and Embodiment 75 lied in that, the vinyl polymer was hyperbranched polymer (a branching degree being 60 branched chains/1000 carbons), the encapsulating glue film with the thickness being 0.5 mm was finally obtained, wherein the melting point of the encapsulating glue film was 120 °C, and the equilibrium torsion at 140 °C was 0.25 dN-m.

Embodiment 79

The difference between Embodiment 79 and Embodiment 55 lied in that, the vinyl polymer further included, by weight, 10 parts of ethylene-vinyl acetate, and the encapsulating glue film with the thickness being 0.5 mm was finally obtained.

Embodiment 80

The difference between Embodiment 80 and Embodiment 55 lied in that, the vinyl polymer further included, by weight, 10 parts of vinyltrimethoxysilane-grafted POE, and the encapsulating glue film with the thickness being 0.5 mm was finally obtained.

Embodiment 81

The difference between Embodiment 81 and Embodiment 55 lied in that, the vinyl polymer further included, by weight, 10 parts of maleic anhydride-grafted POE, and the encapsulating glue film with the thickness being 0.5 mm was finally obtained.

Embodiment 82

30 g of the diethylene glycol dimethacrylate monomer was dissolved into 100 g of ethanol, and poured into a 500 mL round-bottom flask; then 1.35 g of tert-butylperoxy isopropyl carbonate (the amount of the tert-butylperoxy isopropyl carbonate was 4.5% of the monomer), was added, so as to form a mixed solution; the flask was placed into an oil bath pan of 100 °C, stirring was performed, and condensation reflux was performed for 24 hours; and filtration was performed to obtain a white product, and the white product was dried to obtain the three-dimensional polymer, wherein the number-average molecular weight of the three-dimensional polymer was about 8000, which was recorded as P1.

1 part of P1, 0.7 parts of tert-butylperoxy 2-ethylhexyl carbonate (TBEC), 0.7 parts of a co-crosslinking agent triallyl isocyanurate (TAIC) and 0.3 parts of a thickening agent γ-methacryloyloxypropyl trimethoxysilane (KH570) were weighed; the four substances were uniformly mixed, then added to 100 parts of ethylene-octene copolymer (DOW Engage 8411, a melting point being 76 °C, and a melt index being 18 g/10 min) POE particles, and stirred, until the surfaces of the POE particles are dried. The dried POE particles are added to a single-screw extruder, and the temperature of the extruder was 80 °C; a uniform POE melt was formed by means of a melting and shearing effect of a screw; a film was extruded by means of the T-shaped die head, and the temperature of a die head was 100 °C; by means of the extrusion effect of a knurling roll and a rubber roll, a texture structure was formed on the surface of the film; then cooling was performed by means of a plurality of cooling rolls; and finally, rolling-up was performed by means of a wind-up roll, so as to obtain the film with the thickness being 0.5 mm.

Embodiment 83

30 g of the diethylene glycol dimethacrylate monomer was dissolved into 100 g of ethanol, and poured into a

500 mL round-bottom flask; then 0.15g of tert-butylperoxy isopropyl carbonate (the amount of the tert-butylperoxy isopropyl carbonate was 0.5% of the monomer), was added, so as to form a mixed solution; the flask was placed into an oil bath pan of 100 °C, stirring was performed, and condensation reflux was performed for 24 hours; and filtration was performed to obtain a white product, and the white product was dried to obtain the three-dimensional polymer, wherein the number-average molecular weight of the three-dimensional polymer was about 15000, which was recorded as P2.

1 part of P2, 0.7 parts of the tert-butylperoxy 2-ethylhexyl carbonate (TBEC), 0.7 parts of the co-crosslinking agent triallyl isocyanurate (TAIC) and 0.3 parts of the thickening agent γ-methacryloyloxypropyl trimethoxysilane (KH570) were weighed; the four substances were uniformly mixed, then added to 100 parts of the ethylene-octene copolymer (DOW Engage 8411, the melting point being 76°C, and the melt index being 18 g/10 min) POE particles, and stirred, until the surfaces of the POE particles were dried. The dried POE particles were added to a single-screw extruder, and the temperature of the extruder was 80°C; a uniform POE melt was formed by means of a melting and shearing effect of a screw; a film was extruded by means of the T-shaped die head, and the temperature of a die head was 100 °C; by means of the extrusion effect of a knurling roll and a rubber roll, a texture structure was formed on the surface of the film; then cooling was performed by means of a plurality of cooling rolls; and finally, rolling-up was performed by means of a wind-up roll, so as to obtain the film with the thickness being 0.5 mm.

Embodiment 84

30 g of the diethylene glycol dimethacrylate monomer was dissolved into 100 g of ethanol, and poured into a 500 mL round-bottom flask; then 3g of tert-butylperoxy isopropyl carbonate (the amount of the tert-butylperoxy isopropyl carbonate was 10% of the monomer), was added, so as to form a mixed solution; the flask was placed into an oil bath pan of 100 °C, stirring was performed, and condensation reflux was performed for 24 hours; and filtration was performed to obtain a white product, and the white product was dried to obtain the three-dimensional polymer, wherein the number-average molecular weight of the three-dimensional polymer was about 3000, which was recorded as P3.

1 part of P3, 0.7 parts of the tert-butylperoxy 2-ethylhexyl carbonate (TBEC), 0.7 parts of the co-crosslinking agent triallyl isocyanurate (TAIC) and 0.3 parts of the thickening agent γ-methacryloyloxypropyl trimethoxysilane (KH570) were weighed; the four substances were uniformly mixed, then added to 100 parts of the ethylene-octene copolymer (DOW Engage 8411, the melting point being 76°C, and the melt index being 18 g/10 min) POE particles, and stirred, until the surfaces of the POE particles were dried. The dried POE particles were added to a single-screw extruder, and the temperature of the extruder was 80°C; a uniform POE melt was formed by means of a melting and shearing effect of a screw; a film was extruded by means of the T-shaped die head, and the temperature of a die head was 100 °C; by means of the extrusion effect of a knurling roll and a rubber roll, a texture structure was formed on the surface of the film; then cooling was performed by means of a plurality of cooling rolls; and finally, rolling-up was performed by means of a wind-up roll, so as to obtain the film with the thickness being 0.5 mm.

Embodiment 85

30 g of the diethylene glycol dimethacrylate monomer was dissolved into 100 g of ethanol, and poured into a 500 mL round-bottom flask; then 3.5g of tert-butylperoxy isopropyl carbonate (the amount of the tert-butylperoxy isopropyl carbonate was 11.7% of the monomer), was added, so as to form a mixed solution; the flask was placed into an oil bath pan of 100 °C, stirring was performed, and condensation reflux was performed for 24 hours; and filtration was performed to obtain a white product, and the white product was dried to obtain the three-dimensional polymer, wherein the number-average molecular weight of the three-dimensional polymer was about 2500, which was recorded as P4.

1 part of P4, 0.7 parts of the tert-butylperoxy 2-ethylhexyl carbonate (TBEC), 0.7 parts of the co-crosslinking agent triallyl isocyanurate (TAIC) and 0.3 parts of the thickening agent γ-methacryloyloxypropyl trimethoxysilane (KH570) were weighed; the four substances were uniformly mixed, then added to 100 parts of the ethylene-octene copolymer (DOW Engage 8411, the melting point being 76°C, and the melt index being 18 g/10 min) POE particles, and stirred, until the surfaces of the POE particles were dried. The dried POE particles were added to a single-screw extruder, and the temperature of the extruder was 80 °C; a uniform POE melt was formed by means of a melting and shearing effect of a screw; a film was extruded by means of the T-shaped die head, and the temperature of a die head was 100 °C; by means of the extrusion effect of a knurling roll and a rubber roll, a texture structure is formed on the surface of the film; then cooling was performed by means of a plurality of cooling rolls; and finally, rolling-up was performed by means of a wind-up roll, so as to obtain the film with the thickness being 0.5 mm.

Embodiment 86

30 g of the diethylene glycol dimethacrylate monomer was dissolved into 100 g of ethanol, and poured into a 500 mL round-bottom flask; then 0.10g of tert-butylperoxy isopropyl carbonate (the amount of the tert-butylperoxy isopropyl carbonate was 0.3% of the monomer), was added, so as to form a mixed solution; the flask was placed into an oil bath pan of 100 °C, stirring was performed, and condensation reflux was performed for 24 hours; and filtration was performed to obtain a white product, and the white product was dried to obtain the three-dimensional polymer, wherein the number-average molecular weight of the three-dimensional polymer was about 20000, which was recorded as P5.

1 part of P5, 0.7 parts of the tert-butylperoxy 2-ethylhexyl carbonate (TBEC), 0.7 parts of the co-crosslinking agent triallyl isocyanurate (TAIC) and 0.3 parts of the thickening agent γ-methacryloyloxypropyl trimethoxysilane (KH570) were weighed; the four substances were uniformly mixed, then added to 100 parts of the ethylene-octene copolymer (DOW Engage 8411, the melting point being 76°C, and the melt index being 18 g/10 min) POE particles, and stirred, until the surfaces of the POE particles were dried. The dried POE particles were added to a single-screw extruder, and the temperature of the extruder was 80°C; a uniform POE melt was formed by means of a melting and shearing effect of a screw; a film was extruded by means of the T-shaped die head, and the temperature of a die head was 100 °C; by means of the extrusion effect of a knurling roll and a rubber roll, a texture structure was formed on the surface of the film; then cooling was performed by means of a plurality of cooling rolls; and finally, rolling-up was performed by means of a wind-up roll, so as to obtain the film with the thickness being 0.5 mm.

Embodiment 87

30 g of a triethylene glycol dimethacrylate monomer was dissolved into 100 g of ethanol, and poured into a 500 mL round-bottom flask; then 1.35 g of tert-butylperoxy isopropyl carbonate (the amount of the tert-butylperoxy isopropyl carbonate was 4.5% of the monomer), was added, so as to form a mixed solution; the flask was placed into an oil bath pan of 100 °C, stirring was performed, and condensation reflux was performed for 24 hours; and filtration was performed to obtain a white product, and the white product was dried to obtain the three-dimensional polymer, wherein the number-average molecular weight of the three-dimensional polymer was about 8500, which was recorded as P6.

1 part of P6, 0.7 parts of the tert-butylperoxy 2-ethylhexyl carbonate (TBEC), 0.7 parts of the co-crosslinking agent triallyl isocyanurate (TAIC) and 0.3 parts of the thickening agent γ-methacryloyloxypropyl trimethoxysilane (KH570) were weighed; the four substances were uniformly mixed, then added to 100 parts of the ethylene-octene copolymer (DOW Engage 8411, the melting point being 76°C, and the melt index being 18 g/10 min) POE particles, and stirred, until the surfaces of the POE particles were dried. The dried POE particles were added to a single-screw extruder, and the temperature of the extruder was 80°C; a uniform POE melt was formed by means of a melting and shearing effect of a screw; a film was extruded by means of the T-shaped die head, and the temperature of a die head was 100 °C; by means of the extrusion effect of a knurling roll and a rubber roll, a texture structure was formed on the surface of the film; then cooling was performed by means of a plurality of cooling rolls; and finally, rolling-up was performed by means of a wind-up roll, so as to obtain the film with the thickness being 0.5 mm.

Embodiment 88

30 g of a tetraethylene glycol dimethacrylate monomer was dissolved into 100 g of ethanol, and poured into a 500 mL round-bottom flask; then 1.2g of tert-butylperoxy isopropyl carbonate (the amount of the tert-butylperoxy isopropyl carbonate was 4% of the monomer), was added, so as to form a mixed solution; the flask was placed into an oil bath pan of 100 °C, stirring was performed, and condensation reflux was performed for 24 hours; and filtration was performed to obtain a white product, and the white product was dried to obtain the three-dimensional polymer, wherein the number-average molecular weight of the three-dimensional polymer was about 9200, which was recorded as P7.

1 part of P7, 0.7 parts of the tert-butylperoxy 2-ethylhexyl carbonate (TBEC), 0.7 parts of the co-crosslinking agent triallyl isocyanurate (TAIC) and 0.3 parts of the thickening agent γ-methacryloyloxypropyl trimethoxysilane (KH570) were weighed; the four substances were uniformly mixed, then added to 100 parts of the ethylene-octene copolymer (DOW Engage 8411, the melting point being 76°C, and the melt index being 18 g/10 min) POE particles, and stirred, until the surfaces of the POE particles were dried. The dried POE particles were added to a single-screw extruder, and the temperature of the extruder was 80 °C; a uniform POE melt was formed by means of a melting and shearing effect of a screw; a film was extruded by means of the T-shaped die head, and the temperature of a die head was 100 °C; by means of the extrusion effect of a knurling roll and a rubber roll, a texture structure was formed on the surface of the film; then cooling was performed by means of a plurality of cooling rolls; and finally, rolling-up was performed by means of a wind-up roll, so as to obtain the film with the thickness being 0.5 mm.

Embodiment 89

30 g of a pentaethylene glycol dimethacrylate monomer was dissolved into 100 g of ethanol, and poured into a 500 mL round-bottom flask; then 1.8g of tert-butylperoxy isopropyl carbonate (the amount of the tert-butylperoxy

isopropyl carbonate was 6% of the monomer), was added, so as to form a mixed solution; the flask was placed into an oil bath pan of 100 °C, stirring was performed, and condensation reflux was performed for 24 hours; and filtration was performed to obtain a white product, and the white product was dried to obtain the three-dimensional polymer, wherein the number-average molecular weight of the three-dimensional polymer was about 7400, which was recorded as P8.

1 part of P8, 0.7 parts of the tert-butylperoxy 2-ethylhexyl carbonate (TBEC), 0.7 parts of the co-crosslinking agent triallyl isocyanurate (TAIC) and 0.3 parts of the thickening agent γ-methacryloyloxypropyl trimethoxysilane (KH570) were weighed; the four substances were uniformly mixed, then added to 100 parts of the ethylene-octene copolymer (DOW Engage 8411, the melting point being 76°C, and the melt index being 18 g/10 min) POE particles, and stirred, until the surfaces of the POE particles were dried. The dried POE particles were added to a single-screw extruder, and the temperature of the extruder was 80°C; a uniform POE melt was formed by means of a melting and shearing effect of a screw; a film was extruded by means of the T-shaped die head, and the temperature of a die head was 100 °C; by means of the extrusion effect of a knurling roll and a rubber roll, a texture structure was formed on the surface of the film; then cooling was performed by means of a plurality of cooling rolls; and finally, rolling-up was performed by means of a wind-up roll, so as to obtain the film with the thickness being 0.5 mm.

Embodiment 90

The difference between Embodiment 90 and Embodiment 82 lied in that, the polyolefin resin was Mitsui TAFMER DF7350, and the film with the thickness being 0.5 mm was finally obtained, wherein the melting point of the Mitsui TAFMER DF7350 was 55°C, and the melt index was 35 g/10 min.

Embodiment 91

The difference between Embodiment 91 and Embodiment 82 lied in that, the polyolefin resin was Borealis Queo 7007LA, and the film with the thickness being 0.5 mm was finally obtained, wherein the melting point of the 7007LA was 48°C, and the melt index was 6.6 g/10 min.

Embodiment 92

The difference between Embodiment 92 and Embodiment 82 lied in that,

0.5 parts of P1 were weighed, and the film with the thickness being 0.5 mm was obtained finally.

Embodiment 93

The difference between Embodiment 93 and Embodiment 82 lied in that,

1.5 parts of P1 were weighed, and the film with the thickness being 0.5 mm was obtained finally.

Embodiment 94

The difference between Embodiment 94 and Embodiment 82 lied in that,

0.4 parts of P1 were weighed, and the film with the thickness being 0.5 mm was obtained finally.

Embodiment 95

The difference between Embodiment 95 and Embodiment 82 lied in that,

2 parts of P1 were weighed, and the film with the thickness being 0.5 mm was obtained finally.

Embodiment 96

The difference between Embodiment 96 and Embodiment 82 lied in that,

0.3 parts of P1 were weighed, and the film with the thickness being 0.5 mm was obtained finally.

Embodiment 97

The difference between Embodiment 97 and Embodiment 82 lied in that,

2.5 parts of P1 were weighed, and the film with the thickness being 0.5 mm was obtained finally.

Embodiment 98

The difference between Embodiment 98 and Embodiment 82 lied in that,

0.2 parts of P1 were weighed, and the film with the thickness being 0.5 mm was obtained finally.

Embodiment 99

The difference between Embodiment 99 and Embodiment 82 lied in that,

3 parts of P1 were weighed, and the film with the thickness being 0.5 mm was obtained finally.

Embodiment 100

The difference between Embodiment 100 and Embodiment 82 lied in that,

0.1 parts of P1 were weighed, and the film with the thickness being 0.5 mm was obtained finally.

Embodiment 101

The difference between Embodiment 101 and Embodiment 82 lied in that,

5 parts of P1 were weighed, and the film with the thickness being 0.5 mm was obtained finally.

Embodiment 102

The difference between Embodiment 102 and Embodiment 82 lied in that, the co-crosslinking agent was triallyl cyanurate, and the film with the thickness being 0.5 mm was finally obtained.

Embodiment 103

The difference between Embodiment 103 and Embodiment 82 lied in that, the organosiloxane was triethoxyvinylsilane (A151), and the film with the thickness being 0.5 mm was finally obtained.

Embodiment 104

The difference between Embodiment 104 and Embodiment 82 lied in that, the polyolefin resin further includes the copolymer of ethylene and maleic anhydride, and vinyltrimethoxysilane-grafted polyolefin, wherein the mass fraction of ethylene in the copolymer was 70%, and the grafting rate of vinylsilane was 1.2%; and the film with the thickness being 0.5 mm was finally obtained.

Comparative example 1

The difference between Comparative example 1 and Embodiment 2 lied in that, the diethylene glycol dimethacrylate was not added, and the film with the thickness being 0.5 mm was finally obtained.

Comparative example 2

The difference between Comparative example 2 and Embodiment 2 lied in that, the diethylene glycol dimethacrylate (2DEGDMA) was replaced with the ethylene dimethacrylate (EGDMA), and the film with the thickness being 0.5 mm was finally obtained.

Comparative example 3

The difference between Comparative example 3 and Embodiment 2 lied in that, the diethylene glycol dimethacrylate (2DEGDMA) was replaced with the diethylene glycol diacrylate (DEGDA), and the film with the thickness being 0.5 mm was finally obtained.

Comparative example 4

The difference between Comparative example 4 and Embodiment 2 lied in that, the diethylene glycol dimethacrylate (2DEGDMA) was replaced with dipropylene glycol dimethyl acrylate (DPGDMA), and the film with the thickness

being 0.5 mm was finally obtained.

Comparative example 5

The difference between Comparative example 5 and Embodiment 2 lied in that, the diethylene glycol dimethacrylate (2DEGDMA) was replaced with trimethylolpropane trimethacrylate (TMPTMA), and the film with the thickness being 0.5 mm was finally obtained.

Comparative example 6

The difference between Embodiment 6 and Embodiment 23 lied in that, the temperature of melt extrusion was 100 °C, and the encapsulating glue film with the thickness being 0.5 mm was finally obtained.

Comparative example 7

The difference between Comparative example 7 and Embodiment 23 lied in that, the organic peroxide was 2,5-dimethyl-2,5-di(tert-amylperoxy)hexane (a one-minute half-life temperature being 180°C), and the encapsulating glue film with the thickness being 0.5 mm was finally obtained.

Comparative example 8

The difference between Comparative example 8 and Embodiment 55 lied in that, the diethylene glycol dimethacrylate was not added, and the film with the thickness being 0.5 mm was finally obtained.

Comparative example 9

The difference between Comparative example 9 and Embodiment 55 lied in that, the diethylene glycol dimethacrylate (2EGDMA) was replaced with the ethylene dimethacrylate (EGDMA), and the film with the thickness being 0.5 mm was finally obtained.

Comparative example 10

The difference between Comparative example 10 and Embodiment 55 lied in that, the diethylene glycol dimethacrylate (2EGDMA) was replaced with hexaethylene glycol diacrylate (6EGDMA), and the film with the thickness being 0.5 mm was finally obtained.

Comparative example 11

The difference between Comparative example 11 and Embodiment 55 lied in that, the diethylene glycol dimethacrylate (2EGDMA) was replaced with dipropylene glycol dimethyl acrylate (DPGDMA), and the film with the thickness being 0.5 mm was finally obtained.

Comparative example 12

The difference between Comparative example 12 and Embodiment 55 lied in that, the diethylene glycol dimethacrylate (2EGDMA) was replaced with trimethylolpropane trimethacrylate (TMPTMA), and the film with the thickness being 0.5 mm was finally obtained.

Comparative example 13

The difference between Comparative example 13 and Embodiment 82 lied in that, P1 was not added, and the film with the thickness being 0.5 mm was finally obtained.

Comparative example 14

The difference between Comparative example 14 and Embodiment 82 lied in that, the diethylene glycol dimethacrylate (2EGDMA) was replaced with the ethylene dimethacrylate (EGDMA), and the film with the thickness being 0.5 mm was finally obtained.

Comparative example 15

The difference between Comparative example 15 and Embodiment 82 lied in that, the diethylene glycol dimethacrylate (2EGDMA) was replaced with hexaethylene glycol diacrylate (6EGDMA), and the film with the thickness being 0.5 mm was finally obtained.

Comparative example 16

The difference between Comparative example 16 and Embodiment 82 lied in that, the diethylene glycol dimethacrylate (2EGDMA) was replaced with trimethylolpropane trimethacrylate (TMPTMA), and the film with the thickness being 0.5 mm was finally obtained.

The crosslinking degree, adhesion and leakage current of the encapsulating glue film obtained in Embodiments 1 to 22, Embodiments 82 to 104, Comparative examples 1 to 5, and Comparative examples 13 to 16 were tested; and the adhesion and leakage current of the encapsulating glue film obtained in Embodiments 55 to 81 and Comparative examples 8 to 12 were tested. Specific testing methods were shown as follows, and testing results were listed in Table 1.

1. Crosslinking degree

According to the GB/T 29848-2018 standard, the obtained encapsulating glue film was cut into sizes of 10 cm×10 cm; at 150 °C, vacuuming was performed for 5 min, and pressurization was performed for 13 min; and lamination was performed by using a lamination apparatus, to cause the encapsulating glue film to undergo a crosslinking reaction, so as to obtain a laminated film. A certain weight of the film is weighed and recorded as X(g); boiled xylene was used to perform soxhlet extraction on the film for 5 hours; filtration was performed by using a 30-mesh stainless-steel filter screen, and then polymer residues on the filter screen were dried under reduced pressure for 3 hours at 145 °C; and then the mass Y(g) of the polymer residues was calculated, and the crosslinking degree of the encapsulating glue film was calculated by using the following formula:

$$\text{crosslinking degree (weight\%)} = Y/X \times 100\%.$$

2. Adhesion measurement

300 mm×150 mm glass/encapsulating glue film (two layers)/flexible backboard were stacked in order and placed in a vacuum laminator; lamination was performed according to a lamination process for 18 min at 150 °C, so as to obtain a laminated member. The flexible backboard/encapsulating glue film was cut into test samples of 10 mm±0.5 mm every 5 cm in a width direction, so as to test the adhesion between the encapsulating glue film and the glass. According to a test method of GB/T 2790-1995, the adhesion between the encapsulating glue film and the glass was tested on a tension tester at a tensile speed of 100 mm/min±10 mm/min; and an arithmetic mean of three tests was used as the adhesion of the encapsulating glue film, accurate to 1 N/cm.

3. Leakage current testing

The obtained encapsulating glue film was cut into sizes of 10 cm×10 cm; at 150 °C, vacuuming was performed for 5 min, and pressurization was performed for 2 min; and lamination was performed by using the lamination apparatus, to cause a pattern on the surface of the encapsulating glue film to be removed, so as to obtain the encapsulating glue film with the flat surface and the thickness being 0.5 mm; and then the encapsulating glue film was placed in an environment with the temperature being 23 °C and the relative humidity being 50% for 48 hours. KEITHLEY 8009 Resistivity test fixture was used to fix the encapsulating glue film; a KEITHLEY 6517B high-resistance meter to test the leakage current of the encapsulating glue film, and an applied voltage was 100V; and a current was initially recorded when the voltage was applied, that was, the leakage current of the encapsulating glue film.

Table 1

| Embodiment/Comparative example | Crosslinking degree/% | Adhesion/N/cm | Leakage current/pA |
|---|---|---|---|
| Embodiment 1 | 41 | 82 | 77 |
| Embodiment 2 | 78 | 130 | 103 |
| Embodiment 3 | 79 | 128 | 122 |

(continued)

| Embodiment/Comparative example | Crosslinking degree/% | Adhesion/N/cm | Leakage current/pA |
|---|---|---|---|
| Embodiment 4 | 79 | 130 | 134 |
| Embodiment 5 | 43 | 85 | 75 |
| Embodiment 6 | 74 | 152 | 12 |
| Embodiment 7 | 73 | 150 | 5 |
| Embodiment 8 | 73 | 162 | 4 |
| Embodiment 9 | 74 | 160 | 2 |
| Embodiment 10 | 73 | 165 | 1.2 |
| Embodiment 11 | 74 | 168 | 1 |
| Embodiment 12 | 75 | 171 | 0.8 |
| Embodiment 13 | 75 | 170 | 0.5 |
| Embodiment 14 | 75 | 170 | 0.6 |
| Embodiment 15 | 74 | 168 | 4 |
| Embodiment 16 | 73 | 170 | 2 |
| Embodiment 17 | 74 | 160 | 6 |
| Embodiment 18 | 40 | 75 | 75 |
| Embodiment 19 | 41 | 79 | 72 |
| Embodiment 20 | 40 | 79 | 71 |
| Embodiment 21 | 42 | 81 | 73 |
| Embodiment 22 | 43 | 83 | 71 |
| Embodiment 55 | - | 125 | 12 |
| Embodiment 56 | - | 118 | 122 |
| Embodiment 57 | - | 114 | 134 |
| Embodiment 58 | - | 109 | 146 |
| Embodiment 59 | - | 109 | 99 |
| Embodiment 60 | - | 111 | 91 |
| Embodiment 61 | - | 120 | 80 |
| Embodiment 62 | - | 121 | 82 |
| Embodiment 63 | - | 119 | 64 |
| Embodiment 64 | - | 118 | 66 |
| Embodiment 65 | - | 120 | 49 |
| Embodiment 66 | - | 117 | 51 |
| Embodiment 67 | - | 120 | 31 |
| Embodiment 68 | - | 119 | 34 |
| Embodiment 69 | - | 122 | 20 |
| Embodiment 70 | - | 121 | 22 |
| Embodiment 71 | - | 127 | 16 |
| Embodiment 72 | - | 126 | 14 |
| Embodiment 73 | - | 120 | 13 |

(continued)

| Embodiment/Comparative example | Crosslinking degree/% | Adhesion/N/cm | Leakage current/pA |
|---|---|---|---|
| Embodiment 74 | - | 96 | 13 |
| Embodiment 75 | - | 113 | 15 |
| Embodiment 76 | - | 114 | 16 |
| Embodiment 77 | - | 115 | 14 |
| Embodiment 78 | - | 109 | 15 |
| Embodiment 79 | - | 144 | 14 |
| Embodiment 80 | - | 156 | 16 |
| Embodiment 81 | - | 158 | 13 |
| Embodiment 82 | 76 | 184 | 1 |
| Embodiment 83 | 74 | 183 | 8 |
| Embodiment 84 | 75 | 180 | 9 |
| Embodiment 85 | 75 | 181 | 16 |
| Embodiment 86 | 74 | 180 | 15 |
| Embodiment 87 | 74 | 179 | 25 |
| Embodiment 88 | 75 | 181 | 37 |
| Embodiment 89 | 76 | 180 | 50 |
| Embodiment 90 | 70 | 198 | 2 |
| Embodiment 91 | 82 | 167 | 1 |
| Embodiment 92 | 75 | 182 | 6 |
| Embodiment 93 | 74 | 181 | 5 |
| Embodiment 94 | 76 | 180 | 8 |
| Embodiment 95 | 77 | 183 | 7 |
| Embodiment 96 | 75 | 185 | 12 |
| Embodiment 97 | 75 | 181 | 11 |
| Embodiment 98 | 76 | 179 | 20 |
| Embodiment 99 | 76 | 180 | 19 |
| Embodiment 100 | 74 | 179 | 36 |
| Embodiment 101 | 75 | 178 | 34 |
| Embodiment 102 | 61 | 176 | 2 |
| Embodiment 103 | 75 | 154 | 3 |
| Embodiment 104 | 77 | 234 | 2 |
| Comparative example 1 | 71 | 144 | 201 |
| Comparative example 2 | 73 | 156 | 170 |
| Comparative example 3 | 75 | 150 | 192 |
| Comparative example 4 | 76 | 138 | 356 |
| Comparative example 5 | 77 | 132 | 343 |
| Comparative example 8 | - | 111 | 1280 |
| Comparative example 9 | - | 113 | 856 |

(continued)

| Embodiment/Comparative example | Crosslinking degree/% | Adhesion/N/cm | Leakage current/pA |
|---|---|---|---|
| Comparative example 10 | - | 120 | 731 |
| Comparative example 11 | - | 114 | 1045 |
| Comparative example 12 | - | 119 | 1233 |
| Comparative example 13 | 74 | 178 | 358 |
| Comparative example 14 | 75 | 179 | 344 |
| Comparative example 15 | 76 | 180 | 312 |
| Comparative example 16 | 73 | 177 | 355 |

1 g of the encapsulating glue film formed in Embodiments 23 to 54, Comparative example 6 and Comparative example 7 was weighed respectively, and was immersed for 24 hours by using 5 mL of isopropanol, and immersing liquid was taken; the number-average molecular weight (which was recorded as A) of the polyethylene glycol dimethacrylate in each encapsulating glue film was tested by using a liquid chromatography-mass spectrometer (electrospray ESI ion source-time of flight mass spectrometry), the mass ratio (which was recorded as B) of the vinyl polymer to the polyethylene glycol dimethacrylate, and testing results were listed in Table 2.

Table 2

| Embodiment/Comparative example | A | B |
|---|---|---|
| Embodiment 23 | 1500 | 100:1 |
| Embodiment 24 | 1500 | 100:1 |
| Embodiment 25 | 1500 | 100:1 |
| Embodiment 26 | 1500 | 100:1 |
| Embodiment 27 | 1500 | 100:1 |
| Embodiment 28 | 1500 | 100:1 |
| Embodiment 29 | 1200 | 100:1 |
| Embodiment 30 | 1400 | 100:1 |
| Embodiment 31 | 3000 | 100:1 |
| Embodiment 32 | 2000 | 100:1 |
| Embodiment 33 | 1000 | 100:1 |
| Embodiment 34 | 500 | 100:1 |
| Embodiment 35 | 2000 | 100:1 |
| Embodiment 36 | 1700 | 100:1 |
| Embodiment 37 | 1300 | 100:1 |
| Embodiment 38 | 1900 | 100:1 |
| Embodiment 39 | 1000 | 100:1 |
| Embodiment 40 | 1800 | 100:1 |
| Embodiment 41 | 800 | 100:1 |
| Embodiment 42 | 500 | 100:1 |
| Embodiment 43 | 1200 | 100:0.8 |
| Embodiment 44 | 2000 | 100:1.2 |
| Embodiment 45 | 2200 | 100:1.5 |

(continued)

| Embodiment/Comparative example | A | B |
|---|---|---|
| Embodiment 46 | 800 | 100:0.6 |
| Embodiment 47 | 600 | 100:0.4 |
| Embodiment 48 | 2500 | 100:2 |
| Embodiment 49 | 500 | 100:0.2 |
| Embodiment 50 | 3000 | 100:3 |
| Embodiment 51 | 1500 | 100:1 |
| Embodiment 52 | 2000 | 100:1 |
| Embodiment 53 | 500 | 100:1 |
| Embodiment 54 | 500 | 100:1 |
| Comparative example 6 | 242 | 100:1 |
| Comparative example 7 | 400 | 100:1 |

Volume resistivity testing

The encapsulating glue films obtained in Embodiments 23 to 54, Comparative example 6 and Comparative example 7 were respectively cut into sizes of 10 cm×10 cm; at 120°C, pre-heating was performed for 2 min, and then pressing was performed for 1 min, to cause the pattern on the surfaces of the encapsulating glue films to be removed, so as to obtain the glue films with the flat surfaces; and then the encapsulating glue films were placed in an environment with the temperature being 23°C and the relative humidity being 50% for 48 hours. KEITHLEY 8009 Resistivity test fixture was used to fix the encapsulating glue film; and a KEITHLEY 6517B high-resistance meter to test the leakage current of the encapsulating glue film, an applied voltage was 1000V, and charging time was 30s. The volume resistivity of each encapsulating glue film may be directly derived by converting a formula; and testing results were listed in Table 3.

Table 3

| Embodiment/Comparative example | Volume resistivity/Ω·cm |
|---|---|
| Embodiment 23 | 8.0E+16 |
| Embodiment 24 | 7.6E+16 |
| Embodiment 25 | 7.5E+16 |
| Embodiment 26 | 7.6E+16 |
| Embodiment 27 | 8.2E+16 |
| Embodiment 28 | 8.2E+16 |
| Embodiment 29 | 4.4E+16 |
| Embodiment 30 | 6.8E+16 |
| Embodiment 31 | 9.6E+16 |
| Embodiment 32 | 1.4E+17 |
| Embodiment 33 | 2.2E+16 |
| Embodiment 34 | 1.5E+16 |
| Embodiment 35 | 7.9E+16 |
| Embodiment 36 | 9.1E+16 |
| Embodiment 37 | 9.0E+16 |
| Embodiment 38 | 8.7E+16 |

(continued)

| Embodiment/Comparative example | Volume resistivity/Ω·cm |
|---|---|
| Embodiment 39 | 8.9E+15 |
| Embodiment 40 | 6.9E+16 |
| Embodiment 41 | 7.3E+16 |
| Embodiment 42 | 3.5E+16 |
| Embodiment 43 | 9.6E+16 |
| Embodiment 44 | 9.5E+16 |
| Embodiment 45 | 6.0E+16 |
| Embodiment 46 | 7.5E+16 |
| Embodiment 47 | 5.9E+16 |
| Embodiment 48 | 5.3E+16 |
| Embodiment 49 | 1.6E+16 |
| Embodiment 50 | 1.7E+16 |
| Embodiment 51 | 7.3E+16 |
| Embodiment 52 | 1.0E+17 |
| Embodiment 53 | 6.7E+16 |
| Embodiment 54 | 1.1E+16 |
| Comparative example 6 | 1.2E+14 |
| Comparative example 7 | 4.5E+14 |

It may be seen from the above description that, in the above embodiments of the present disclosure, the following technical effects are realized.

Polar polyethylene glycol dimethacrylate and non-polar polyolefin resin are thermodynamically incompatible, and when the polyolefin resin is heated and melted, the polyethylene glycol dimethacrylate is delaminated and aggregated in the polyolefin resin. Meanwhile, primary radicals produced by means of thermal decomposition of the organic peroxide make the gathered polyethylene glycol dimethacrylate rapidly undergo a radical polymerization reaction, such that a polymer network structure that has a three-dimensional network structure and that has several ester groups and ether bonds is formed in situ in a polyolefin resin matrix. The polymer network structure can adsorb residual metal ions in the polyolefin resin, thereby reducing the mobility of the metal ions, so as to improve the dry insulation resistance of the polyolefin resin. In addition, the encapsulating composition has simple components, readily available raw materials and low costs.

If the n is less than 2, the molecular weight of the polyethylene glycol dimethacrylate is too low, resulting in easy precipitation of the polyethylene glycol dimethacrylate in the polyolefin resin matrix, such that the effect of the polyethylene glycol dimethacrylate cannot achieved; and if the n is greater than 5, the viscosity of the polyethylene glycol dimethacrylate is too large, not facilitating mixing processing, such that a synergistic effect of the polyethylene glycol dimethacrylate with the organic peroxide is not achieved.

Since polyethylene glycol dimethacrylate in the encapsulating composition is a polymer network structure that has a three-dimensional network structure and that has several ester groups and ether bonds. The polymer network structure can adsorb residual metal ions in the vinyl polymer, thereby reducing the mobility of the metal ions, so as to improve the dry insulation resistance of the vinyl polymer. In addition, a method for preparing an encapsulating glue film by using the encapsulating composition is simple, and has readily available raw materials and low costs.

The polyolefin resin and the monomer can be uniformly mixed at room temperature. However, when the polyolefin resin is heated and melted, the polar monomer and the non-polar polyolefin resin are thermodynamically incompatible, resulting in certain aggregation of monomer molecules. Meanwhile, the monomer forms a hyperbranched polymer that has several ester groups and ether bonds in situ in the polyolefin resin matrix by means of ultraviolet light initiated polymerization or radiation initiated polymerization. The hyperbranched polymer structure can weaken the mobility of the metal ions or deprive the metal ions of electron conduction, thereby reducing the mobility of the metal ions, so as to

improve the dry insulation resistance of the polyolefin resin. In addition, the composition has simple components, readily available raw materials, less process steps, and low costs. If the n is less than 2, the molecular weight of the monomer is too low, resulting in easy precipitation of the monomer in the polyolefin resin matrix, such that the effect of the monomer cannot achieved; and if the n is greater than 5, the viscosity of the monomer is too large, not facilitating mixing processing, and increasing polymerization difficulty.

The structure of the three-dimensional polymer generally refers to a polymer system which is formed by means of polymerization of a dobby monomer in a three-dimensional space. Since the monomer forming the three-dimensional polymer in the present disclosure contains two olefinic unsaturated bonds, the three-dimensional polymer obtained by means of polymerization of the monomer contains several ether bonds and ester groups. Oxygen atoms in the ether bonds and the ester groups contain lone pair electrons. In addition, by means of the synergistic effect between the two oxygen atoms, the residual metal ions in the polyolefin resin are chelated together, such that the metal ions are weakened or deprived their electron conduction, so as to improve the insulation resistance of the polyolefin resin. In addition, the composition has simple components, readily available raw materials, and low costs.

The above are only the preferred embodiments of the present disclosure and are not intended to limit the present disclosure, for those skilled in the art, the present disclosure may have various modifications and variations. Any modifications, equivalent replacements, improvements and the like made within the spirit and principle of the present disclosure all fall within the scope of protection of the present disclosure.

## Claims

1. An encapsulating composition, the encapsulating composition comprises polyolefin resin, polyethylene glycol dimethacrylate and organic peroxide, the structural formula of the polyethylene glycol dimethacrylate is represented as:

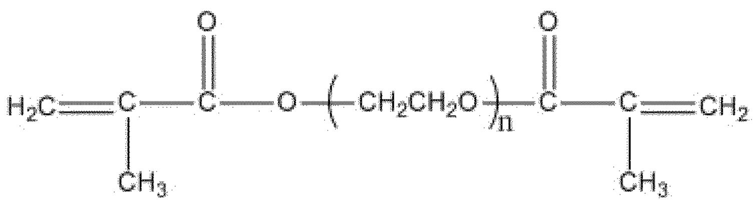

,

wherein n is an integer of 2-5.

2. The encapsulating composition according to claim 1, wherein a mass ratio of the polyethylene glycol dimethacrylate to the organic peroxide is 0.3:1-2.1:1, preferably, 0.7:1-1.7:1.

3. The encapsulating composition according to claim 1 or 2, wherein the n is 2-4, preferably the n is 2-3, and further preferably, the n is 2.

4. The encapsulating composition according to claim 1, the encapsulating composition comprises, by weight:

100 parts of the polyolefin resin;
0.1-3 parts of the polyethylene glycol dimethacrylate; and
0.1-2 parts of the organic peroxide, wherein
preferably, the polyethylene glycol dimethacrylate is 0.15-2.5 parts, further preferably 0.2-2.0 parts, further preferably 0.3-1.5 parts, and still further preferably 0.5-1.2 parts;
preferably, the organic peroxide is selected from a combination of any one or more of diacyl peroxide, dialkyl peroxide, peroxide ester and ketal peroxide; preferably, the peroxide ester is selected from a combination of any one or more of ethyl 3,3-bis(tert-butylperoxy)butyrate, ethyl 3,3-bis(tert-amylperoxy)butyrate, tert-butyl peroxybenzoate, tert-butyl peroxyacetate, tert-butylperoxy isopropyl carbonate, tert-butyl peroxy-3,5,5-trimethylhexanoate, tert-butylperoxy 2-ethylhexyl carbonate, n-butyl 4,4-bis(tert-butylperoxy)valerate, tert-amyl peroxybenzoate, tert amyl peroxyacetate, tert-amyl peroxy-3,5,5-trimethylhexanoate, tert-amyl peroxy 2-ethylhexyl carbonate, tert amyl peroxyisobutyrate and 2,5-dimethyl-2,5-bis(benzoylperoxy)-hexane; preferably, the diacyl peroxide is selected from a combination of any one or more of benzoyl peroxide, lauric peroxide and decanoic acid peroxide; preferably, the ketal peroxide is selected from a combination of any one or more of 2,2-di(tert-butylperoxy)butane, 1,1-di(tert-butylperoxy)cyclohexane, 1,1-di-(tert-butylperoxy)-3,3,5-trimethylcyclohexane,

1,1-bis(tert-amylperoxy)cyclohexane and 1,1-di-(tert-amylperoxy)-3,3,5-trimethylcyclohexane; and preferably, the dialkyl peroxide is diisopropylbenzene peroxide and/or 2,5-dimethyl-2,5-di(tert-butylperoxy)hexane.

5. The encapsulating composition according to any of claims 1 to 4, wherein the polyolefin resin comprises copolymer of ethylene and $C_{3-20}$ $\alpha$ olefin; preferably, the polyolefin resin is selected from a combination of any one or more of ethylene-propylene copolymer, ethylene-butene copolymer, ethylene-octene copolymer, and ethylene-propylene-octene copolymer; preferably, the melting point of the polyolefin resin is 40-80 °C; and preferably, the melt index of the polyolefin resin is 3-20 g/10 min.

6. The encapsulating composition according to any of claims 1 to 5, the encapsulating composition further comprises, by weight, 0.2-3 parts of a co-crosslinking agent, wherein preferably, the co-crosslinking agent is a compound that comprises at least three double bonds; further preferably, the co-crosslinking agent is the compound having an annular structure; and further preferably, the co-crosslinking agent is triallyl isocyanurate and/or triallyl cyanurate.

7. The encapsulating composition according to any of claims 1 to 6, the encapsulating composition further comprises, by weight, 0.1-1.5 parts of organosiloxane, wherein preferably, the organosiloxane simultaneously comprises an olefinic group and a hydrolyzable group; further preferably, the organosiloxane is trialkoxysilane; and further preferably, the trialkoxysilane is selected from a combination of any one or more of $\gamma$-methacryloyloxypropyl trimethoxysilane, vinyltrimethoxysilane, triethoxyvinylsilane, vinyl tris($\beta$-methoxyethoxy) silane, and allyltrimethoxysilane.

8. An encapsulating composition, the encapsulating composition comprises vinyl polymer, diethylene glycol dimethacrylate and organic peroxide, the structural formula of the diethylene glycol dimethacrylate is represented as:

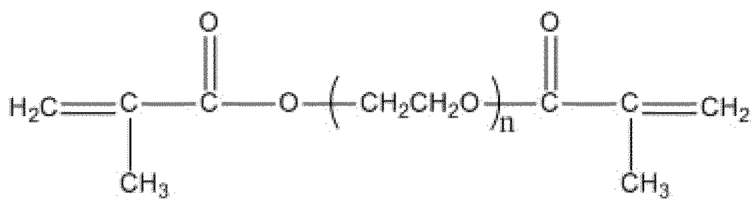

,

wherein n=2.

9. The encapsulating composition according to claim 8, wherein a mass ratio of the diethylene glycol dimethacrylate to the organic peroxide is 3-20:1, preferably, 5-15:1, and further preferably 7-12:1.

10. The encapsulating composition according to claim 8, the encapsulating composition comprises, by weight:

100 parts of the vinyl polymer;
0.2-3 parts of the diethylene glycol dimethacrylate; and
0.1-2 parts of the organic peroxide, wherein
preferably, the polyethylene glycol dimethacrylate is 0.4-2 parts, further preferably 0.6-1.5 parts, and further preferably 0.8-1.2 parts;
preferably, the one-minute half-life temperature of the organic peroxide is 130-170 °C; and preferably, the organic peroxide is selected from any one or more of tert-butyl peroxyacetate, tert-butylperoxy isopropyl carbonate, tert-butyl peroxy-3,5,5-trimethylhexanoate, tert-butylperoxy 2-ethylhexyl carbonate, tert-amyl peroxybenzoate, tert amyl peroxyacetate, tert-amyl peroxy-3,5,5-trimethylhexanoate, tert-amyl peroxy 2-ethylhexyl carbonate, tert-butyl peroxyisobutyrate, 2,5-dimethyl-2,5-bis(benzoylperoxy)-hexane, benzoyl peroxide, 2,2-di(tert-butylperoxy)butane, 1,1-di(tert-butylperoxy)cyclohexane, 1,1-di-(tert-butylperoxy)-3,3,5-trimethylcyclohexane, 1,1-bis(tert-amylperoxy)cyclohexane and 1,1-di-(tert-amylperoxy)-3,3,5-trimethylcyclohexane.

11. The encapsulating composition according to any of claims 8 to 10, wherein the vinyl polymer is thermoplastic vinyl polymer; and the melting point of the vinyl polymer is 85-125 °C, preferably 90-120 °C, and further preferably 95-115 °C.

12. The encapsulating composition according to any of claims 8 to 10, wherein an equilibrium torsion of the vinyl polymer at 140°C is 0.1-0.3 dN-m.

**13.** The encapsulating composition according to any of claims 8 to 10, wherein the vinyl polymer comprises a combination of any one or more of polyethylene, hyperbranched polyethylene and ethylene-α olefin copolymer; preferably, the density of the polyethylene is 0.91-0.93 g/$cm^3$; preferably, the branching degree of the hyperbranched polyethylene is 40-140 branched chains/1000 carbons; and preferably, the ethylene-α olefin copolymer is selected from any one or more ethylene-butene copolymer, ethylene-octene copolymer and ethylene-propylene-hexene copolymer.

**14.** The encapsulating composition according to claim 11, wherein the vinyl polymer further comprises a combination of any one or more of ethylene-vinyl acetate, ethylene-methyl methacrylate, ethylene-acrylic acid copolymer, and silane-grafted polyolefin.

**15.** A composition, the composition is a non-peroxide initiated composition, the composition comprises polyolefin resin and a monomer, the monomer comprises a compound shown in a structural formula I:

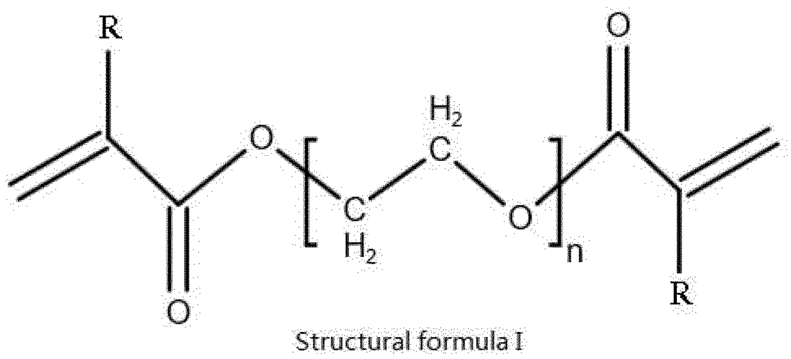

Structural formula I

wherein R is H or methyl, and n is an integer of 2-5; and a polymerization mode of the monomer is ultraviolet light initiated polymerization, or radiation initiated polymerization, or microwave initiated polymerization.

**16.** The composition according to claim 15, wherein the n is 2-4, preferably the n is 2-3, and further preferably, the n is 2.

**17.** The composition according to claim 15 or 16, the composition comprises, by weight:

100 parts of the polyolefin resin; and
0.05-5 parts of the monomer, wherein preferably, the monomer is 0.1-3 parts, further preferably 0.2-2 parts, further preferably 0.3-1.5 parts, further preferably 0.4-1.2 parts, and more preferably 0.5-1 part.

**18.** The composition according to any of claims 15 to 17, wherein the polyolefin resin comprises copolymer of ethylene and $C_{3-20}$ α olefin; preferably, the polyolefin resin is selected from a combination of any one or more of ethylene-propylene copolymer, ethylene-butene copolymer, ethylene-octene copolymer, and ethylene-propylene-octene copolymer; preferably, the melting point of the polyolefin resin is 40-85 °C; and preferably, the melt index of the polyolefin resin is 3-40 g/10 min.

**19.** The composition according to any of claims 15 to 17, the composition further comprises, by weight, 0.1-3 parts of a co-crosslinking agent, wherein preferably, the co-crosslinking agent is a compound that comprises at least three double bonds; further preferably, the co-crosslinking agent is the compound having an annular structure; and further preferably, the co-crosslinking agent is triallyl isocyanurate and/or triallyl cyanurate.

**20.** The composition according to any of claims 15 to 17, the composition further comprises, by weight, 0.1-1.5 parts of organosiloxane, wherein preferably, the organosiloxane simultaneously comprises an olefinic group and a hydrolyzable group; further preferably, the organosiloxane is a trialkoxysilane compound; and further preferably, the trialkoxysilane is selected from a combination of any one or more of γ-methacryloyloxypropyl trimethoxysilane, vinyltrimethoxysilane, triethoxyvinylsilane, vinyl tris(β-methoxyethoxy) silane, and allyltrimethoxysilane.

**21.** The composition according to any of claims 15 to 17, wherein the polyolefin resin in the composition is vinyl polymer, and the monomer is diethylene glycol dimethacrylate.

**22.** The composition according to claim 21, wherein the vinyl polymer is thermoplastic vinyl polymer; the melting point

of the vinyl polymer is 86-125 °C, preferably 90-120 °C, and further preferably 95-115 °C;
Preferably, the vinyl polymer comprises a combination of any one or more of polyethylene, hyperbranched polyethylene and ethylene-α olefin copolymer; preferably, the density of the polyethylene is 0.91-0.93 g/cm$^3$; preferably, the branching degree of the hyperbranched polyethylene is 40-140 branched chains/1000 carbons; and preferably, the ethylene-α olefin copolymer is selected from any one or more ethylene-butene copolymer, ethylene-octene copolymer and ethylene-propylene-hexene copolymer.

**23.** The composition according to claim 22, wherein the vinyl polymer further comprises a combination of any one or more of ethylene-vinyl acetate, ethylene-methyl acrylate copolymer, ethylene-acrylic acid copolymer, ethylene-glycidyl methacrylate copolymer, ethylene-acrylate-glycidyl methacrylate copolymer, maleic anhydride-grafted polyolefin, and silane-grafted polyolefin.

**24.** The composition according to claim 22, wherein the shape of the composition is selected from any one of a granule, a flake, a strip, or a tube.

**25.** A composition, the composition comprises polyolefin resin, and a three-dimensional polymer containing ester groups and ether bonds, a structural formula of a monomer forming the three-dimensional polymer is represented as:

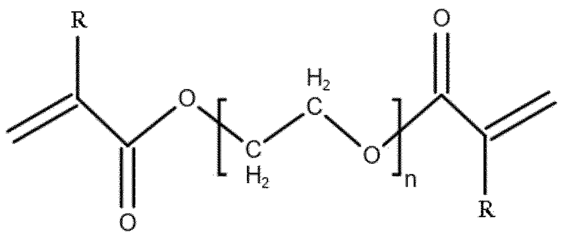,

wherein n is an integer of 2-5, and R is H or $CH_3$.

**26.** The composition according to claim 25, the composition further comprises organic peroxide.

**27.** The composition according to claim 25 or 26, wherein the n is 2-4, preferably the n is 2-3, and further preferably, the n is 2.

**28.** The composition according to claim 25 or 26, wherein the three-dimensional polymer is a hyperbranched polymer, and the number-average molecular weight of the hyperbranched polymer is 3000-15000.

**29.** The composition according to claim 25, wherein the polyolefin resin comprises any one or more of homopolymer or copolymer formed by means of coordination polymerization of ethylene, propylene and $C_{4-20}$ α olefin; and preferably, the polyolefin resin is selected from a combination of any one or more of ethylene-propylene copolymer, ethylene-butene copolymer, ethylene-octene copolymer, and ethylene-propylene-octene copolymer.

**30.** The composition according to claim 26 or 27, the composition comprises, by weight:

100 parts of the polyolefin resin;
0.1-5 parts of the three-dimensional polymer; and
0.1-2 parts of the organic peroxide, wherein
preferably, the three-dimensional polymer is 0.2-3 parts, further preferably 0.3-2.5 parts, further preferably 0.4-2 parts, and more preferably 0.5-1.5 parts;
preferably, the organic peroxide is selected from a combination of any one or more of diacyl peroxide, dialkyl peroxide, peroxide ester and ketal peroxide; preferably, the peroxide ester is selected from a combination of any one or more of ethyl 3,3-bis(tert-butylperoxy)butyrate, ethyl 3,3-bis(tert-amylperoxy)butyrate, tert-butyl peroxybenzoate, tert-butyl peroxyacetate, tert-butylperoxy isopropyl carbonate, tert-butyl peroxy-3,5,5-trimethylhexanoate, tert-butylperoxy 2-ethylhexyl carbonate, n-butyl 4,4-bis(tert-butylperoxy)valerate, tert-amyl peroxybenzoate, tert amyl peroxyacetate, tert-amyl peroxy-3,5,5-trimethylhexanoate, tert-amyl peroxy 2-ethylhexyl carbonate, tert amyl peroxyisobutyrate and 2,5-dimethyl-2,5-bis(benzoylperoxy)-hexane; preferably, the diacyl peroxide is selected from a combination of any one or more of benzoyl peroxide, lauric peroxide and decanoic acid peroxide; preferably, the ketal peroxide is selected from a combination of any one or more of 2,2-di(tert-butylperoxy)butane, 1,1-di(tert-butylperoxy)cyclohexane, 1,1-di-(tert-butylperoxy)-3,3,5-trimethylcyclohexane, 1,1-bis(tert-amylperoxy)cyclohexane and 1,1-di-(tert-amylperoxy)-3,3,5-trimethylcyclohexane; and preferably, the dialkyl peroxide is diisopropylbenzene peroxide and/or 2,5-dimethyl-2,5-di(tert-butylperoxy)hexane.

**31.** The composition according to claim 29, wherein the melting point of the polyolefin resin is 40-90 °C; and the melt index of the polyolefin resin is 3-50 g/10 min.

**32.** The composition according to any of claims 25 to 30, the composition further comprises, by weight, 0.2-3 parts of a co-crosslinking agent, wherein preferably, the co-crosslinking agent is a compound that comprises at least three double bonds; further preferably, the co-crosslinking agent is the compound having an annular structure; and further preferably, the co-crosslinking agent is triallyl isocyanurate and/or triallyl cyanurate.

**33.** The composition according to any of claims 25 to 30, the composition further comprises, by weight, 0.1-1.5 parts of organosiloxane, wherein preferably, the organosiloxane simultaneously comprises an olefinic group and a hydrolyzable group; further preferably, the organosiloxane is a trialkoxysilane compound; and further preferably, the trialkoxysilane is selected from a combination of any one or more of γ-methacryloyloxypropyl trimethoxysilane, vinyltrimethoxysilane, triethoxyvinylsilane, vinyl tris(β-methoxyethoxy) silane, and allyltrimethoxysilane.

**34.** The composition according to claim 25, wherein the polyolefin resin further comprises copolymer of ethylene and any one or more of vinyl acetate, acrylate, methacrylate, acrylic acid, glycidyl methacrylate and maleic anhydride; and the mass fraction of the ethylene in the copolymer is greater than 60%.

**35.** The composition according to claim 25, wherein the polyolefin resin further comprises vinylsilane-grafted polyolefin; and the grafting rate of vinylsilane is 0.1-2%, and further, the vinylsilane is preferably vinyltrimethoxysilane.

**36.** The composition according to any of claims 25 to 35, wherein the shape of the composition is selected from any one of a granule, a flake, a tube, or a strip.

**37.** An encapsulating glue film, obtained by mixing and performing melt extrusion on components in a composition, wherein the composition is the encapsulating composition according to any of claims 1 to 14, or the composition is the composition according to any of claims 15 to 36.

**38.** The encapsulating glue film according to claim 37, wherein a method for preparing the encapsulating glue film by using vinyl polymer, organic peroxide and diethylene glycol dimethacrylate of the encapsulating composition as raw materials comprises:

S1, mixing the vinyl polymer, the organic peroxide and the diethylene glycol dimethacrylate, so as to obtain a mixture; and
S2, performing melt extrusion on the mixture, so as to obtain the encapsulating glue film, wherein
the temperature of melt extrusion is 120-150 °C, the one-minute half-life temperature of the organic peroxide is less than or equal to 170 °C, and preferably, the rotary speed of the mixture at a melt extrusion phase is 10-40 rpm/min.

**39.** The encapsulating glue film according to claim 37, wherein a method for preparing the encapsulating glue film by using vinyl polymer and diethylene glycol dimethacrylate of the composition as raw materials comprises:

S1, mixing the vinyl polymer and the diethylene glycol dimethacrylate, so as to obtain a mixture;
S2, performing melt extrusion on the mixture, so as to obtain an extruded film; and
S3, performing ultraviolet light irradiation or radiation on the extruded film, so as to obtain the encapsulating glue film, wherein
preferably, radiation is selected from any one or more of α-ray radiation, β-ray radiation, γ-ray radiation and X-ray radiation, and more preferably, a radiation dosage absorbed by the extruded film is 1-100 KGy.

**40.** The encapsulating glue film according to claim 37, the encapsulating glue film is a single-layer encapsulating glue film or a multi-layer co-extrusion encapsulating glue film.

**41.** The encapsulating glue film according to claim 37, the encapsulating glue film comprises vinyl polymer and polyethylene glycol dimethacrylate.

**42.** The encapsulating glue film according to claim 37, wherein a mass ratio of the vinyl polymer to the polyethylene glycol dimethacrylate is 100:0.2-3, preferably 100:0.4-2, further preferably 100:0.6-1.5, and more preferably 100:0.8-1.2.

**43.** The encapsulating glue film according to claim 41 or 42, wherein the number-average molecular weight of the polyethylene glycol dimethacrylate is 500-3000.

**44.** The encapsulating glue film according to any of claims 41 to 43, wherein the vinyl polymer is thermoplastic vinyl polymer; and the melting point of the vinyl polymer is 85-125 °C, preferably 90-120 °C, and further preferably 95-115 °C.

**45.** The encapsulating glue film according to any of claims 41 to 43, wherein an equilibrium torsion of the vinyl polymer at 140°C is 0.1-0.3 dN-m.

**46.** The encapsulating glue film according to any of claims 41 to 43, wherein the vinyl polymer comprises a combination of any one or more of polyethylene, hyperbranched polyethylene and ethylene-α olefin copolymer; preferably, the density of the polyethylene is 0.91-0.93 g/cm$^3$; preferably, the branching degree of the hyperbranched polyethylene is 40-140 branched chains/1000 carbons; and preferably, the ethylene-α olefin copolymer is selected from any one or more ethylene-butene copolymer, ethylene-octene copolymer and ethylene-propylene-hexene copolymer.

**47.** The encapsulating glue film according to claim 44, wherein the vinyl polymer further comprises a combination of any one or more of ethylene-vinyl acetate, ethylene-methyl methacrylate, ethylene-acrylic acid copolymer, and silane-grafted polyolefin.

**48.** An electronic component, the electronic component comprises any one of a solar cell, a liquid crystal panel, an electroluminescent device, a plasma display device or a touch screen, wherein at least one surface of the electronic component is in contact with an encapsulating glue film; and the encapsulating glue film is the encapsulating glue film according to any of claims 37 to 47.

**49.** A solar cell assembly, comprising a solar cell, wherein at least one surface of the solar cell is in contact with an encapsulating glue film; and the encapsulating glue film is the encapsulating glue film according to any of claims 37 to 47.

**INTERNATIONAL SEARCH REPORT**

International application No.
**PCT/CN2021/103007**

**A. CLASSIFICATION OF SUBJECT MATTER**

C09J 4/02(2006.01)i; C09J 7/10(2018.01)i; C09J 7/30(2018.01)i; C09J 123/00(2006.01)i; C09J 123/08(2006.01)i; C09J 151/06(2006.01)i; H01L 31/048(2014.01)i

According to International Patent Classification (IPC) or to both national classification and IPC

**B. FIELDS SEARCHED**

Minimum documentation searched (classification system followed by classification symbols)

C09J4, C09J7, C09J123, C09J151, H01L31

Documentation searched other than minimum documentation to the extent that such documents are included in the fields searched

Electronic data base consulted during the international search (name of data base and, where practicable, search terms used)

CNABS, WPABSC, USTXTC, CNKI, CNTXT, VEN, WOTXT, EPTXT, USTXT, GOOGLE, ISI, 万方, 读秀, Caplus, Reg; 杭州福斯特, 魏梦娟, 唐国栋, 周光大, 侯宏兵, 周欣蕊, 兰松青, 王龙, ((乙二醇 or 乙二酯 OR 甘醇) 4D (二甲基丙烯酸 or 二丙烯酸 OR 双丙烯酸 or 双甲基丙烯酸)) OR 2DEGDMA OR 3EGDMA or 4EGDMA OR 5EGDMA, 聚烯烃 or 聚乙烯 or 聚丙烯 or 聚丁烯 or ((乙烯 or 丙烯 or 丁烯 or 烯烃) 6w (共聚物 or 聚合物 or 均聚物)) or POE or EVA or (乙烯 2w (醋酸乙烯 or 乙酸乙烯)), 太阳能 or 电池 or 光伏, 离子 s (吸附 or 络合 or 固定 or 迁移 or 移动 or 捕捉 or 捕集), 电阻, 绝缘, (+ethylene glycol) 4D (dimethacrylate or diacrylate), ?DEGDMA, ?EGDMA, Metal ion, cation, catch+, fix???, insulation, Resistivity, encapsulant, seal???, +voltaic, solar cell, batter???, ethylene, +olefin?, POE, EVA, acetate.

**C. DOCUMENTS CONSIDERED TO BE RELEVANT**

| Category* | Citation of document, with indication, where appropriate, of the relevant passages | Relevant to claim No. |
|---|---|---|
| X | CN 108034372 A (HANGZHOU FIRST APPLIED MATERIAL CO., LTD.) 15 May 2018 (2018-05-15)<br>Embodiment 6 | 1-7, 37, 40-49 |
| X | CN 111454668 A (HANGZHOU FIRST APPLIED MATERIAL CO., LTD.) 28 July 2020 (2020-07-28)<br>embodiment 4 | 1-14, 37-49 |
| PX | CN 112831284 A (ZHEJIANG XIANGLONG TECHNOLOGY CO., LTD.) 25 May 2021 (2021-05-25)<br>Embodiment 3 | 15-24, 37-49 |
| X | CN 108517188 A (HANGZHOU FIRST APPLIED MATERIAL CO., LTD.) 11 September 2018 (2018-09-11)<br>embodiment 12 | 1-7, 37, 40-49 |

☑ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **10 September 2021** | **26 September 2021** |

| Name and mailing address of the ISA/CN | Authorized officer |
|---|---|
| **China National Intellectual Property Administration (ISA/CN)**<br>**No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**

International application No.
**PCT/CN2021/103007**

**C. DOCUMENTS CONSIDERED TO BE RELEVANT**

| Category* | Citation of document, with indication, where appropriate, of the relevant passages | Relevant to claim No. |
|---|---|---|
| X | CN 102391568 A (DONGFANG TURBINE CO., LTD., DONGFANG ELECTRIC CORPORATION) 28 March 2012 (2012-03-28) embodiment 9 | 1-14, 37-49 |
| A | US 2020216647 A1 (HANGZHOU XINGLU TECH. CO., LTD.) 09 July 2020 (2020-07-09) entire document | 1-49 |
| A | CN 101506996 A (BRIDGESTONE CORP.) 12 August 2009 (2009-08-12) entire document | 1-49 |
| A | US 2009120489 A1 (MITSUI DU PONT POLYCHEMICAL) 14 May 2009 (2009-05-14) entire document | 1-49 |

Form PCT/ISA/210 (second sheet) (January 2015)

**INTERNATIONAL SEARCH REPORT**
**Information on patent family members**

International application No.
**PCT/CN2021/103007**

| Patent document cited in search report | Publication date (day/month/year) | Patent family member(s) | Publication date (day/month/year) |
|---|---|---|---|
| CN 108034372 A | 15 May 2018 | CN 108034372 B | 23 June 2020 |
| CN 111454668 A | 28 July 2020 | None | |
| CN 112831284 A | 25 May 2021 | None | |
| CN 108517188 A | 11 September 2018 | None | |
| CN 102391568 A | 28 March 2012 | None | |
| US 2020216647 A1 | 09 July 2020 | CN 109337156 A | 15 February 2019 |
| | | CN 109370478 A | 22 February 2019 |
| | | CN 109370453 A | 22 February 2019 |
| | | WO 2019019986 A1 | 31 January 2019 |
| CN 101506996 A | 12 August 2009 | WO 2008023722 A1 | 28 February 2008 |
| | | ES 2552715 T3 | 01 December 2015 |
| | | US 2010229946 A1 | 16 September 2010 |
| | | EP 2056356 A1 | 06 May 2009 |
| | | EP 2056356 A4 | 13 October 2010 |
| | | CN 101506996 B | 20 June 2012 |
| | | EP 2056356 B1 | 19 August 2015 |
| | | JP 2008053379 A | 06 March 2008 |
| | | US 8148625 B2 | 03 April 2012 |
| | | JP 4751792 B2 | 17 August 2011 |
| US 2009120489 A1 | 14 May 2009 | JP 4842923 B2 | 21 December 2011 |
| | | JP 2011199296 A | 06 October 2011 |
| | | EP 1863098 A1 | 05 December 2007 |
| | | US 8053086 B2 | 08 November 2011 |
| | | EP 1863098 A4 | 23 March 2011 |
| | | CN 101138095 A | 05 March 2008 |
| | | CN 101138095 B | 06 October 2010 |
| | | JP WO2006095762 A1 | 14 August 2008 |
| | | EP 1863098 B1 | 08 July 2015 |
| | | WO 2006095762 A1 | 14 September 2006 |

Form PCT/ISA/210 (patent family annex) (January 2015)